# EUROPEAN PATENT APPLICATION

(11) **EP 4 411 981 A1**
(43) Date of publication of application: **07.08.2024**
(21) Application number: 21959543.6
(22) Date of filing: 01.10.2021
(51) Int. Cl.: H01Q 1/32, H01Q 1/38, H01Q 5/20

(54) **WIDEBAND ANTENNA ARRANGED ON VEHICLE**

(71) Applicant: LG Electronics Inc., Yeongdeungpo-gu Seoul 07336 (KR)
(72) Inventor: YUN, Changwon, Seoul 06772 (KR); KIM, Yongkon, Seoul 06772 (KR); KIM, Changil, Seoul 06772 (KR); JEON, Cheolsoo, Seoul 06772 (KR)
(74) Representative: Vossius & Partner Patentanwälte Rechtsanwälte mbB
(86) International application number: PCT/KR2021/013507
(87) International publication number: WO 2023/054772

(57) **Abstract**

An antenna module mounted on a vehicle, according to an embodiment, is provided. The antenna module comprises: a PCB having a transmission line; a lower cover on which the PCB is arranged; an upper cover which is fastened to the lower cover so as to accommodate the PCB therein, and which has a metal plate formed in a partial region formed of a dielectric; a slot radiator, which radiates a radio signal through a slot region formed in the metal plate and a partial region of the upper cover; and a feeding structure, which transmits the radio signal to the slot radiator so that the radio signal of the transmission line formed on the PCB is radiated through the slot radiator.

## Description

### Technical Field

This specification relates to a wideband antenna disposed in a vehicle. One particular implementation relates to an antenna module having a wideband antenna that is capable of operating in various communication systems, and to a vehicle having the same.

### Background Art

A vehicle may perform wireless communication services with other vehicles or nearby objects, infrastructures, or a base station. In this regard, various communication services may be provided using Long Term Evolution (LTE) communication, 5G communication, or WiFi communication technology.

In order to provide these various wireless communication services in a vehicle, an antenna may be disposed on a glass of the vehicle, above or below a roof of the vehicle. When the antenna is disposed on the glass of the vehicle, it may be implemented with a transparent antenna material. Meanwhile, when the antenna is disposed above or below the roof of the vehicle, an effect on a vehicle body and the roof of the vehicle may cause a change in antenna performance.

In this regard, there is a problem in that the vehicle body and the vehicle roof are formed of a metallic material to block radio waves. Accordingly, a separate antenna structure may be disposed above the vehicle body or the roof. Or, when the antenna structure is disposed below the vehicle body or roof, a portion of the vehicle body or roof corresponding to a region where the antenna structure is disposed may be formed of a non-metallic material.

Meanwhile, in order to provide 4G communication or 5G communication services such as LTE communication, an antenna element disposed within the antenna module corresponding to the antenna structure needs to operate in a wide range. Frequency bands for 4G communication or 5G communication include a low band (LB), a mid band (MB), and a high band (HB). In this regard, antenna elements for 4G communication or 5G communication need to be designed to be wideband so as to cover the bandwidth of low band (LB). In particular, the low band (LB) of 4G communication or 5G communication has a high relative bandwidth ratio to a center frequency compared to the mid band (MB) and the high band (HB). Accordingly, there is a problem in that it is difficult to satisfy an antenna bandwidth requirement in the low band (LB).

However, existing antenna elements are implemented as resonance antenna elements with a limited bandwidth, so there is a problem in that bandwidth characteristics are limited.

### Disclosure of Invention

### Technical Problem

This specification is directed to solving the aforementioned problems and other drawbacks. In addition, another aspect of this specification is to provide a wideband antenna element capable of performing a wideband operation while being disposed in a vehicle.

Another aspect of this specification is to provide a high-efficiency wideband antenna element having a high antenna gain while operating in a wide bandwidth.

Another aspect of this specification is to maintain antenna performance at a predetermined level even in a case where the exterior of a vehicle body or roof is made of a metallic material.

Another aspect of the present disclosure is to improve antenna performance of an antenna system while maintaining a height of the antenna system at a predetermined level or less.

Another aspect of the present disclosure is to provide a structure for mounting an antenna system, which is capable of operating in a broad frequency band to support various communication systems, to a vehicle.

### Solution to Problem

In order to achieve the foregoing or other objectives, an antenna module mounted on a vehicle according to an embodiment is provided. The antenna module may include a PCB having a transmission line disposed thereon; a bottom cover in which the PCB is disposed; a top cover fastened to the bottom cover to accommodate the PCB therein, the top cover having a metal plate disposed in a partial region made of a dielectric; a slot radiator configured to radiate a wireless signal through a slot region disposed on the metal plate and a partial region of the top cover; and a feeding structure configured to transmit a wireless signal of the transmission line disposed on the PCB to the slot radiator so as to radiate the wireless signal through the slot radiator.

According to an embodiment, the slot radiator may be disposed to have a first length in a first axis direction with respect to a center point of the slot region, and configured to gradually increase in width in a second axis direction with respect to the center point.

According to an embodiment, the metal plate may be disposed in a side region of the top cover. The slot radiator may be configured to surround the slot region at a first frequency in an operating band of the slot radiator, and may operate in a slot mode by a current distribution formed in different directions in upper and lower regions of the slot region. The slot radiator may operate in a patch mode by a current distribution formed in the same direction on the metal plate at a second frequency higher than the first frequency.

According to an embodiment, the metal plate may be disposed in an inner region of the top cover and disposed above the PCB in parallel to the PCB. The slot radiator may operate in a first synthesis mode in which a slot mode and a patch mode are synthesized at a first frequency in an operating band of the slot radiator. The slot radiator may operate in the slot mode at a second frequency higher than the first frequency.

According to an embodiment, the slot mode may be configured such that a current distribution is formed in different directions in upper and lower regions of the slot region. The patch mode may be configured such that a current distribution is formed in the same direction on the metal plate.

According to an embodiment, the slot radiator may operate in a second synthesis mode in which the slot mode and the patch mode are synthesized at a third frequency between the first frequency and the second frequency. The slot radiator may operate in the first synthesis mode at a fourth frequency between the third frequency and the second frequency. A direction of a current distribution formed in the slot region in the second synthesis mode may be formed in a direction opposite to that of a current distribution formed in the slot region in the first synthesis mode.

According to an embodiment, the metal plate may be formed using an injection method to be attached to a partial region of the top cover.

According to an embodiment, the transmission line may be a CPW transmission line having ground patterns disposed on both sides of a signal line. The metal plate may be disposed on a side region of the top cover. The metal plate may be connected to the feeding structure connected in perpendicular to the signal line of the CPW transmission line.

According to an embodiment, the antenna module may further include an auxiliary PCB disposed perpendicular to the PCB. The metal plate may be disposed on the top cover, and a CPW transmission line is disposed on the auxiliary PCB having ground patterns disposed on both sides of a signal line. The metal plate may be coupled to the feeding structure connected in perpendicular to the signal line of the CPW transmission line to be spaced apart therefrom by a predetermined distance or connected thereto.

According to an embodiment, the feeding structure may include a first connection portion connected in perpendicular to the signal line of the CPW transmission line and extending to a point higher than the center point of the slot region in a height direction of the auxiliary PCB so that a wireless signal is coupled to the slot region. The feeding structure may further include a second connection portion configured to be spaced apart from the metal plate by a predetermined distance at a point higher than the center point.

According to an embodiment, the second connection portion may be disposed more adjacent to the metal plate than the first connection portion such that a second distance at which the second connection portion is spaced apart from the metal plate is smaller than a first distance at which the first connection portion is spaced apart from the metal plate.

According to an embodiment, the first connection portion may be configured with a first width and a first length to ensure impedance matching between the transmission line and the slot radiator when a wireless signal is applied to the slot region. The second connection portion may be configured with a second width wider than the first width and a second length shorter than the first length.

According to an embodiment, the antenna module may further include a second radiator connected to the signal line of the CPW transmission line and disposed perpendicular to the metal plate. The slot radiator may operate in a first band, and the second radiator may operate in a second band higher than the first band.

According to an embodiment, the slot radiator may be connected to a first feed line of the signal line, and the second radiator may be connected to a second feed line of the signal line. A first signal in the first band transmitted to the first feed line and a second signal in the second band transmitted to the second feed line may be separated from each other by a diplexer.

According to an embodiment, the slot radiator and the second radiator may be connected by the signal line provided with a filter part consisting of one or more filters. It may be configured such that the first signal in the first band transmitted through the signal line is transmitted to the slot radiator but not transmitted to the second radiator by the filter part. It may be configured such that the second signal in the second band transmitted through the signal line is transmitted to the second radiator but not transmitted to the first radiator by the filter part.

According to an embodiment, the slot region may include a first region disposed in a tapering structure to gradually increase in width in the second axis direction with respect to the center point that is coupling-fed by the feeding structure. The slot region may further include a second region disposed to have a constant width in the second axis direction.

According to an embodiment, the first region of the slot region may be disposed in a first side region of the top cover, and at least part of the second region may be disposed in a second side region adjacent to the first side region.

A vehicle according to another aspect of this specification may include an antenna module disposed below a roof of the vehicle; and a processor disposed inside or outside the antenna module, and configured to communicate with at least one of an adjacent vehicle, a road side unit (RSU), and a base station. The antenna module may further include a PCB having a transmission line disposed thereon; a bottom cover having the PCB disposed therein, the bottom cover configured to be attached to the vehicle; a top cover fastened to the bottom cover to accommodate the PCB therein, the top cover having a metal plate disposed in a partial region made of a dielectric; a slot radiator configured to radiate a wireless signal through a slot region disposed on the metal plate and a partial region of the top cover; and a feeding structure configured to transmit a wireless signal of the transmission line disposed on the PCB to the slot radiator so as to radiate the wireless signal through the slot radiator.

According to an embodiment, the slot radiator may be disposed to have a first length in a first axis direction with respect to a center point of the slot region, and configured to gradually increase in width in a second axis direction with respect to the center point.

According to an embodiment, the transmission line may be a CPW transmission line having ground patterns disposed on both sides of a signal line. The metal plate may be disposed on a side region of the top cover. The metal plate may be connected to or coupled to the feeding structure connected in perpendicular to the signal line of the CPW transmission line to be spaced apart therefrom. The feeding structure may include a first connection portion connected in perpendicular to the signal line of the CPW transmission line and extending to a point higher than the center point of the slot region in a height direction of the PCB so that a wireless signal is coupled to the slot region. The feeding structure may further include a second connection portion configured to be spaced apart from the metal plate by a predetermined distance at a point higher than the center point.

According to an embodiment, the antenna module may further include an auxiliary PCB disposed perpendicular to the PCB. The metal plate may be disposed on the top cover, and a CPW transmission line may be disposed on the auxiliary PCB having ground patterns disposed on both sides of a signal line. The metal plate may be connected to or coupled to the feeding structure connected in perpendicular to the signal line of the CPW transmission line to be spaced apart therefrom. The feeding structure may include a first connection portion connected in perpendicular to the signal line of the CPW transmission line and extending to a point higher than the center point of the slot region in a height direction of the auxiliary PCB so that a wireless signal is coupled to the slot region. The feeding structure may further include a second connection portion configured to be spaced apart from the metal plate by a predetermined distance at a point higher than the center point.

According to an embodiment, the antenna module may further include a second radiator connected to a signal line of the transmission line and disposed perpendicular to the metal plate. The slot radiator may operate in a first band, and the second radiator may operate in a second band higher than the first band. The antenna module may include a first antenna and a second antenna consisting of the slot radiator and the second radiator. The processor may control to transmit and receive a signal in a first band through the first antenna. The processor may control to perform multi-input multi-output (MIMO) in a second band higher than the first band through the first antenna and the second antenna. In this regard, an area of a metal region surrounding a second region where the second antenna is disposed may be larger than that of a first region where the first antenna is disposed.

### Advantageous Effects of Invention

The technical effects of such an antenna module having a wideband antenna element in a vehicle and a vehicle equipped with the antenna module will be described as follows.

According to this specification, it aims to provide a bow-tie type wideband antenna element capable of operating in a low band (LB) of the 4G/5G band while being disposed in a vehicle.

According to this specification, a high-efficiency wideband antenna element having a high antenna gain while operating in a wideband may be implemented through a structure in which a bow-tie type antenna element is connected to a feed line on a PCB.

According to this specification, a wideband antenna element may be disposed on a surface of a non-metallic antenna module, thereby maintaining antenna performance at a predetermined level even when the exterior of a vehicle body or roof is formed of a metal material.

According to this specification, a wideband antenna element may be disposed on a surface of a non-metallic antenna module, thereby improving antenna performance while maintaining a height of an entire antenna system below a predetermined level.

According to this specification, a structure for mounting an antenna system capable of operating in a wideband on a vehicle to support various communication systems may be presented.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

### Brief Description of Drawings

FIG. 1A is a diagram illustrating an internal configuration of a vehicle in accordance with one example. FIG. 1B is a lateral view illustrating the vehicle interior in accordance with the one example.
FIG. 2A is a diagram illustrating a type of V2X application.
FIG. 2B is a view illustrating a standalone scenario supporting V2X SL communication and an MR-DC scenario supporting V2X SL communication.
FIGS. 3A to 3C are views illustrating a structure for mounting an antenna system in a vehicle, to which the antenna system is mounted.
FIG. 4 is a block diagram illustrating a vehicle and an antenna system mounted to the vehicle in accordance with one example.
FIG. 5 shows various configurations in which an antenna element is disposed in an upper region, a side region, and a lower region of a top cover in an antenna module.
FIG. 6A shows a side view of a configuration in which an antenna element according to this specification is disposed in a side region of a top cover in an antenna module consisting of a top cover and a bottom cover. FIG. 6B shows a transmission line configured to feed an antenna element according to this specification.
FIG. 7A shows a configuration in which a transmission line and an antenna element implemented on a PCB disposed in a bottom cover of the antenna module are coupled to each other. FIG. 7B shows an exploded state of the antenna element that can be coupled to the transmission line implemented on the PCB of FIG. 7A prior to being coupled to each other. FIG. 7C is a front view of a slot radiator of FIGS. 7A and 7B, which is seen from a front side thereof.
FIGS. 8A and 8B show a VSWR and an antenna efficiency of a wideband antenna element presented herein.
FIGS. 9A and 9B show electric field distributions at first and second frequencies of a wideband antenna element presented herein.
FIGS. 10A and 10B show current distributions formed on a surface of a wideband antenna element presented herein at first and second frequencies.
FIG. 11A is an exploded view of an antenna module including a PCB and a radiator module having an antenna element that can be disposed in a front region of a top cover. Meanwhile, FIG. 11B is an enlarged view of the radiator module of FIG. 11A.
FIG. 12A is a side view of an antenna module including the slot radiator of FIG. 11A. In addition, FIG. 12B shows an example of a feeding structure formed in various sizes for feeding a wireless signal to a slot radiator connected to an auxiliary PCB.
FIGS. 13A and 13B show an antenna input impedance characteristic and a VSWR according to a change in width and length of a second connection portion of a feeding structure.
FIG. 14 shows a configuration in which an antenna element is disposed in parallel to a bottom cover and a VSWR characteristic of the antenna element according to this configuration.
FIG. 15 shows current distributions formed on a metal plate at different frequencies in a low band (LB).
FIG. 16 shows a radiator module having a separate feed structure.
FIG. 17 shows a radiator module with a single feed structure.
FIG. 18 shows VSWRs of antennas according to the feeding structures of FIGS. 16 and 17.
FIG. 19A shows a structure in which radiator modules are disposed at different locations on a PCB.
FIG. 19B shows a gain characteristic of a radiator module disposed at a specific location as a roof formed of a metal material is disposed in a vehicle.
FIG. 20 shows a configuration diagram of an antenna system according to an embodiment and a vehicle on which the antenna system is mounted.

### Mode for the Invention

Hereinafter, preferred embodiments of the present disclosure will be described in detail with reference to the accompanying drawings, and the same or similar elements are designated with the same numeral references regardless of the numerals in the drawings and redundant description thereof will be omitted. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings. The idea of the present disclosure should be construed to extend to any alterations, equivalents and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer elements, functions, or steps may likewise be utilized.

An antenna system described herein may be mounted on a vehicle. Configurations and operations according to implementations may also be applied to a communication system, namely, antenna system mounted on a vehicle. In this regard, the antenna system mounted in the vehicle may include a plurality of antennas, and a transceiver circuit and a processor that control the plurality of antennas.

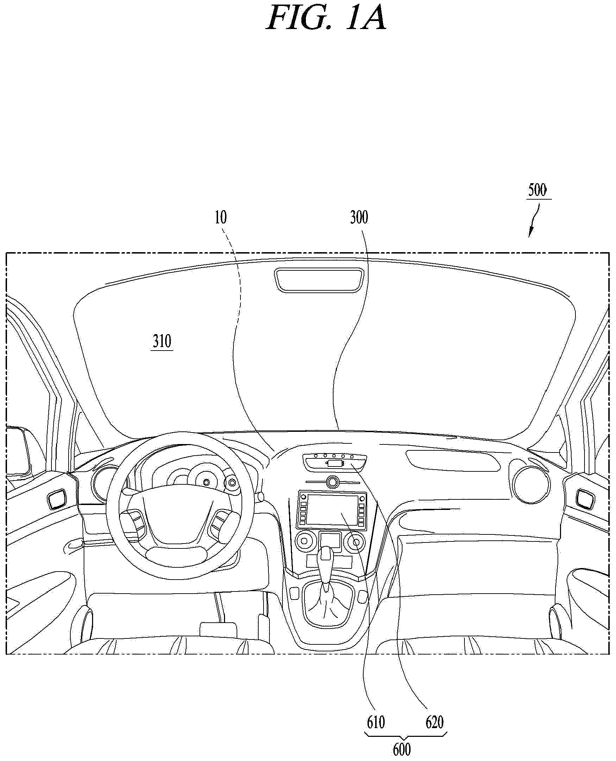

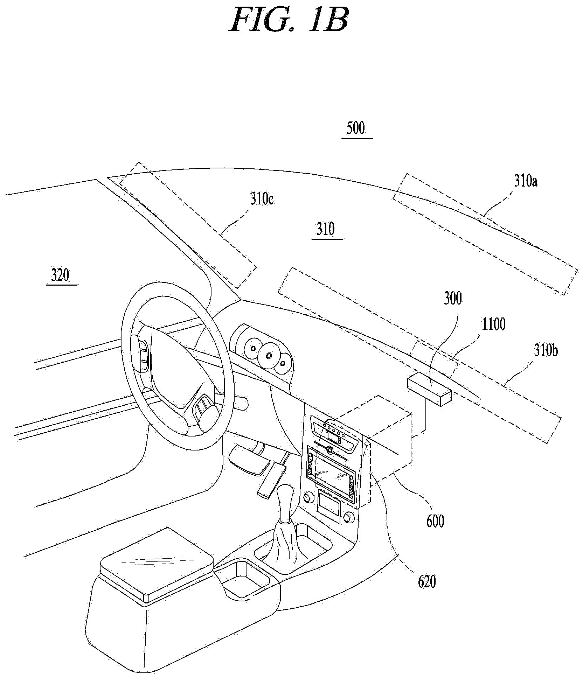

FIG. 1A is a diagram illustrating an internal configuration of a vehicle in accordance with one example. FIG. 1B is a lateral view illustrating the vehicle interior in accordance with the one example.

As illustrated in FIGS. 1A and 1B, the present disclosure describes an antenna unit (i.e., an internal antenna system) 1000 capable of transmitting and receiving signals through GPS, 4G wireless communication, 5G wireless communication, Bluetooth, or wireless LAN. Therefore, the antenna unit (i.e., the antenna system) 1000 capable of supporting these various communication protocols may be referred to as an integrated antenna module 1000. The antenna system 1000 may include a telematics control unit (TCU) 300 and an antenna assembly 1100. For example, the antenna assembly 1100 may be disposed on a window of a vehicle.

The present disclosure also describes a vehicle 500 having the antenna system 1000. The vehicle 500 may include a dashboard and a housing 10 including the telematics control unit (TCU) 300, and the like. In addition, the vehicle 500 may include a mounting bracket for mounting the telematics control unit (TCU) 300.

The vehicle 500 may include the telematics control unit (TCU) 300 and an infotainment unit 600 configured to be connected to the telematics control unit 300. A portion of a front pattern of the infotainment unit 600 may be implemented in the form of a dashboard of the vehicle. A display 610 and an audio unit 620 may be included in the dashboard of the vehicle.

The antenna assembly 1100, namely, the antenna module 1100 in the form of a transparent antenna may be disposed in at least one of an upper region 310a, a lower region 310b, and a side region 310c of a front window 310. The antenna assembly 1100 may also be disposed at a side window 320, which is disposed at a side surface of the vehicle, in addition to the front window 310.

As illustrated in FIG. 1B, when the antenna assembly 1100 is disposed at the lower region 310b of the front window 310, it may be operably coupled to a TCU 300 disposed inside the vehicle. When the antenna assembly 1100 is disposed at the upper region 310a or the side region 310c of the front window 310, it may be operably coupled to a TCU disposed outside the vehicle. However, the present disclosure may not be limited to the TCU coupling configuration inside or outside the vehicle.

### <V2X (Vehicle-to-Everything)>

V2X communication may include communications between a vehicle and all entities, such as V2V (Vehicle-to-Vehicle) which refers to communication between vehicles, V2I (Vehicle-to-Infrastructure) which refers to communication between a vehicle and an eNB or RSU (Road Side Unit), V2P (Vehicle-to-Pedestrian) which refers to communication between a vehicle and a terminal possessed by a person (pedestrian, cyclist, vehicle driver, or passenger), V2N (vehicle-to-network), and the like.

V2X communication may have the same meaning as V2X sidelink or NR V2X or may have, in a broader sense, a meaning including V2X sidelink or NR V2X.

V2X communication may be applicable to various services, for example, forward collision warning, an automatic parking assist system, cooperative adaptive cruise control (CACC), control-loss warning, traffic queuing warning, safety warning, traffic vulnerable-area safety warning, emergency vehicle warning, curved-road driving speed warning, and traffic flow control.

V2X communication may be provided through a PC5 interface and/or a Uu interface. In this case, specific network entities for supporting communications between a vehicle and all entities may exist in a wireless communication system supporting V2X communication. For example, the network entity may include a base station (eNB), a Road Side Unit (RSU), a terminal, or an application server (e.g., a traffic safety server).

In addition, a terminal performing V2X communication may refer to not only a general handheld UE but also a vehicle (V-UE), a pedestrian UE, an RSU of an eNB type, an RSU of a UE type, a robot equipped with a communication module, and the like.

V2X communication may be performed directly between terminals or may be performed through the network entity (entities). V2X operation modes may be classified according to a method of performing such V2X communication.

Terms used in V2X communication may be defined as follows.

A road side unit (RSU) is a V2X service enabled device that can transmit and receive data to and from a moving vehicle using V2I service. The RSU also serves as a stationary infrastructure entity that supports V2X application programs, and may exchange messages with other entities that support V2X application programs. The RSU is a term frequently used in existing ITS specifications, and the reason for employing the term RSU in association with the 3GPP specifications is to read relevant documents in an easier manner in the ITS industry. The RSU is a logical entity that combines a V2X application logic with the functionality of an eNB (referred to as an eNB-type RSU) or a UE (referred to as a UE-type RSU).

V2I Service is a type of V2X service, where one party is a vehicle whereas the other party is an entity belonging to infrastructure. A V2P Service is a type of V2X service, where one party is a vehicle whereas the other party is an entity belonging to an infrastructure. A V2X Service is a type of 3GPP communication service that involves a transmitting or receiving device on a vehicle. The V2X service may further be divided into a V2V service, a V2I service, and a V2P service according to which partner is involved in communication for the V2X service.

V2X enabled UE is a UE that supports V2X service. The V2V Service is a type of V2X service, where both parties involved in communication are vehicles. V2V communication range is a direct communication range between two vehicles involved in the V2V service.

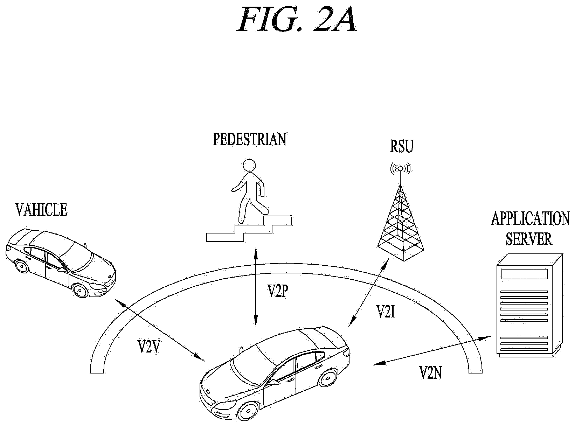

Four types of V2X applications called Vehicle-to-Everything (V2X), as described above, include (1) vehicle-to-vehicle (V2V), (2) vehicle-to-infrastructure (V2I), (3) vehicle-to-network (V2N), (4) vehicle-to-pedestrian (V2P). FIG. 2A illustrates types of V2X applications. Referring to FIG. 2A, the four types of V2X applications may use "cooperative awareness" to provide more intelligent services for end-users.

This means that, in order to provide more intelligent information, such as cooperative collision warning or autonomous traveling, entities, such as vehicles, roadside-based facilities, application servers and pedestrians, may collect knowledge of involved local environments (e.g., information received from nearby vehicles or sensor equipment) to process and share the corresponding knowledge.

### <NR V2X>

Support for V2V and V2X services has been introduced in LTE during Releases 14 and 15, in order to expand the 3GPP platform to the automotive industry.

Requirements for support of enhanced V2X use cases are largely organized into four use case groups.
(1) Vehicles Platooning enables the vehicles to dynamically form a platoon traveling together. All the vehicles in the platoon obtain information from the leading vehicle to manage this platoon. This information allows the vehicles to drive closer than normal in a coordinated manner, going to the same direction and traveling together.
(2) Extended Sensors enable the exchange of raw or processed data gathered through local sensors or live video images among vehicles, road site units, devices of pedestrians and V2X application servers. The vehicle can recognize an environment much more than through detection by its sensor and can recognize a local situation as a whole in a more extensive manner. A high data transmission rate is one of primarily features of the extended sensor.
(3) Advanced Driving enables semi-automated or full-automated driving. The advanced driving enables each vehicle and/or each RSU to share self-recognition data obtained from a local sensor with a nearby vehicle and to synchronize and adjust a trajectory or a maneuver. Each vehicle shares its intention to drive with a nearby vehicle.
(4) Remote driving serves to enable a remote driver or a V2X application program to drive a remotely-located vehicle in a dangerous environment by him/herself or itself or instead of an occupant who cannot drive the remotely-located vehicle. In a case where a traffic environment is limitedly changed and a vehicle driving path is predictable such as in public transportation, driving based on cloud computing may be available. High reliability and low latency are main requirements for the remote driving.

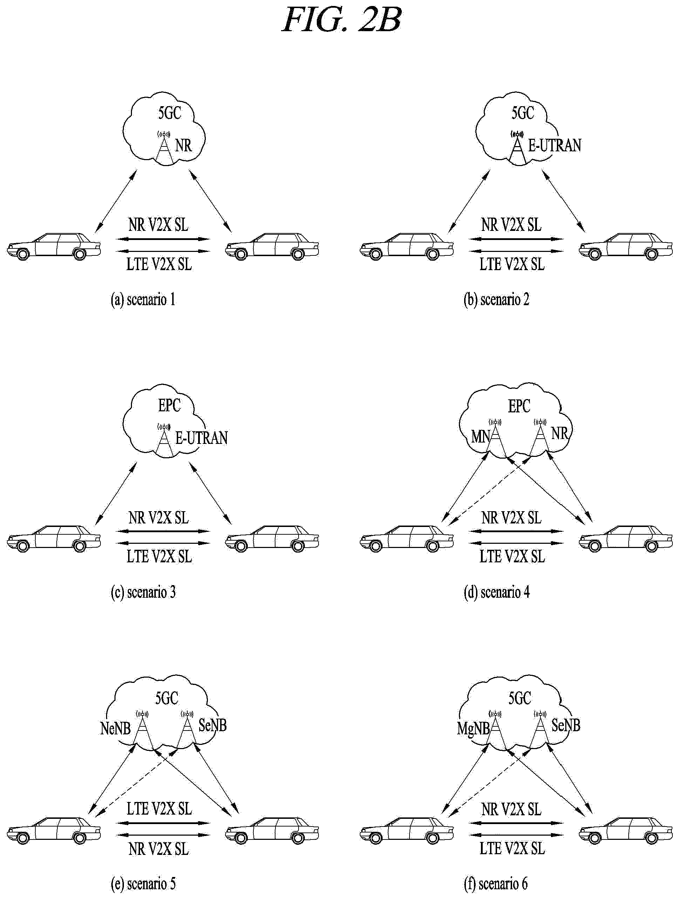

A description to be given below may be applicable to all of NR SL (sidelink) and LTE SL, and when no radio access technology (RAT) is indicated, the NR SL is meant. Six operational scenarios considered in NR V2X may be considered as follows. In this regard, FIG. 2B illustrates a standalone scenario supporting V2X SL communication and an MR-DC scenario supporting V2X SL communication.

In particular, 1) in Scenario 1, gNB provides control/configuration for UE's V2X communication in both LTE SL and NR SL. 2) In Scenario 2, ng-eNB provides control/configuration for UE's V2X communication in both LTE SL and NR SL. 3) In Scenario 3, eNB provides control/configuration for UE's V2X communication in both LTE SL and NR SL. On the other hand, 4) in Scenario 4, the UE's V2X communication in the LTE SL and the NR SL is controlled/configured by Uu while the UE is configured with EN-DC. 5) In Scenario 5, the UE's V2X communication in the LTE SL and the NR SL is controlled/configured by Uu while the UE is configured in NE-DC. 6) In Scenario 6, the UE's V2X communication in the LTE SL and the NR SL is controlled/configured by Uu while the UE is configured in NGEN-DC.

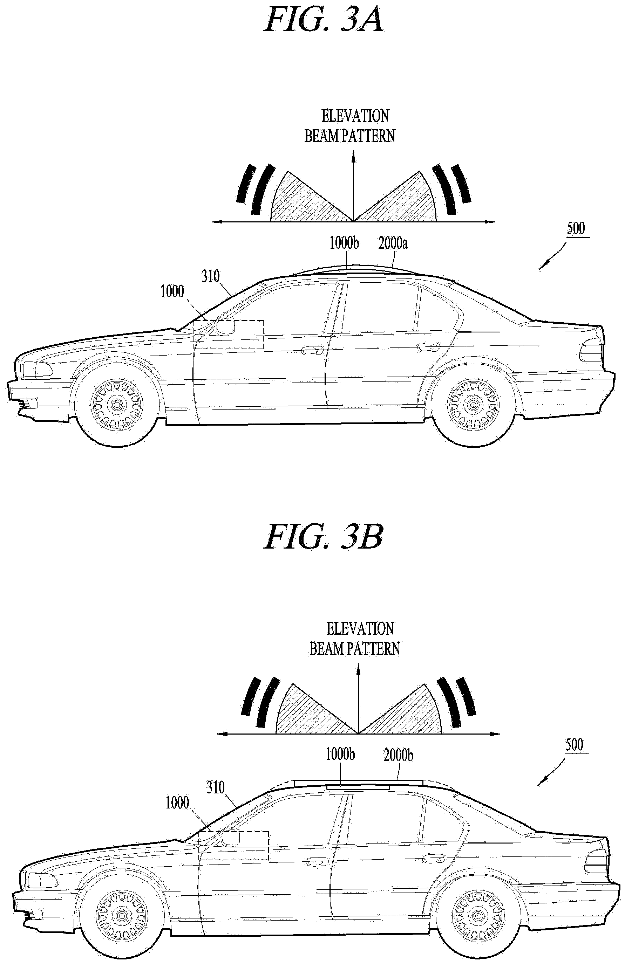

In order to support the V2X communication, as illustrated in FIGS. 2A and 2B, the vehicle may perform wireless communication with eNB and/or gNB through an antenna system. The antenna system may be configured as an internal antenna system as illustrated in FIGS. 1A and 1B. The antenna system may alternatively be implemented as an external antenna system and/or an internal antenna system as illustrated in FIGS. 3A to 3C.

FIGS. 3A to 3C are views illustrating an example of a structure for mounting an antenna system on a vehicle, which includes the antenna system mounted on the vehicle. In this regard, FIGS. 3A to 3C illustrate a configuration capable of performing wireless communication through a transparent antenna disposed on the front window 310 of the vehicle. An antenna system 1000 including a transparent antenna may be disposed on a front window of a vehicle and inside the vehicle. Wireless communication may also be performed through a transparent antenna disposed on a side glass of the vehicle, in addition to the front window.

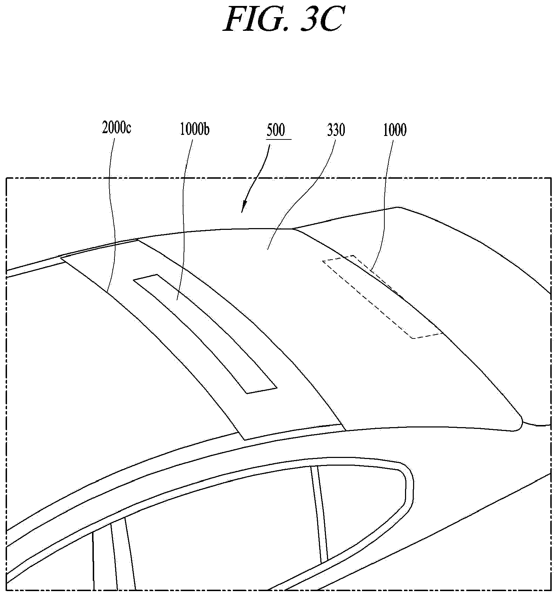

The antenna system for the vehicle that includes the transparent antenna can be combined with other antennas. Referring to FIGS. 3A to 3C, in addition to the antenna system 1000 implemented as the transparent antenna, a separate antenna system 1000b may be further configured. FIGS. 3A and 3B illustrate a structure in which the antenna system 1000b, in addition to the antenna system 1000, is mounted on or in a roof of the vehicle. On the other hand, FIG. 3C illustrates a structure in which the separate antenna system 1000b, in addition to the antenna system 1000, is mounted in a roof frame of a roof and a rear mirror of the vehicle.

Referring to FIGS. 3A to 3C, in order to improve the appearance of the vehicle and to maintain a telematics performance at the time of collision, an existing shark fin antenna may be replaced with a flat antenna of a non-protruding shape. In addition, the present disclosure proposes an integrated antenna of an LTE antenna and a 5G antenna considering fifth generation (5G) communication while providing the existing mobile communication service (e.g., LTE).

Referring to FIG. 3A, the antenna system 1000 implemented as the transparent antenna may be disposed on the front window 310 of the vehicle and inside the vehicle. The second antenna system 1000b corresponding to an external antenna may be disposed on the roof of the vehicle. In FIG. 3A, a radome 2000a may cover the second antenna system 1000b to protect the second antenna system 1000b from an external environment and external impacts while the vehicle travels. The radome 2000a may be made of a dielectric material through which radio signals are transmitted/received between the second antenna system 1000b and a base station.

Referring to FIG. 3B, the antenna system 1000 implemented as the transparent antenna may be disposed on the front window 310 of the vehicle and inside the vehicle. One the other hand, the second antenna system 1000b corresponding to the external antenna may be disposed within a roof structure of the vehicle and at least part of the roof structure may be made of a non-metallic material. At this time, the roof structure 2000b of the vehicle except for the at least part made of the non-metallic material may be made of a dielectric material through which radio signals are transmitted/received between the antenna system 1000b and the base station.

Referring to FIG. 3C, the antenna system 1000 implemented as the transparent antenna may be disposed on the rear window 330 of the vehicle and inside the vehicle. The second antenna system 1000b corresponding to the external antenna may be disposed within the roof frame 2000c of the vehicle, and at least part of the roof frame 2000c may be made of a non-metallic material. At this time, the roof frame 2000c of the vehicle 500 except for the at least part made of the non-metallic material may be made of a dielectric material through which radio signals are transmitted/received between the second antenna system 1000b and the base station.

Referring to FIGS. 3A to 3C, antennas provided in the antenna system 1000 mounted on the vehicle may form a beam pattern in a direction perpendicular to the front window 310 or the rear window 330. Antenna provided in the second antenna system 1000 mounted on the vehicle may further define a beam coverage by a predetermined angle in a horizontal region with respect to the vehicle body.

Meanwhile, the vehicle 500 may include only the antenna unit (i.e., the internal antenna system) 1000 corresponding to the internal antenna without the antenna system 1000b corresponding to the external antenna.

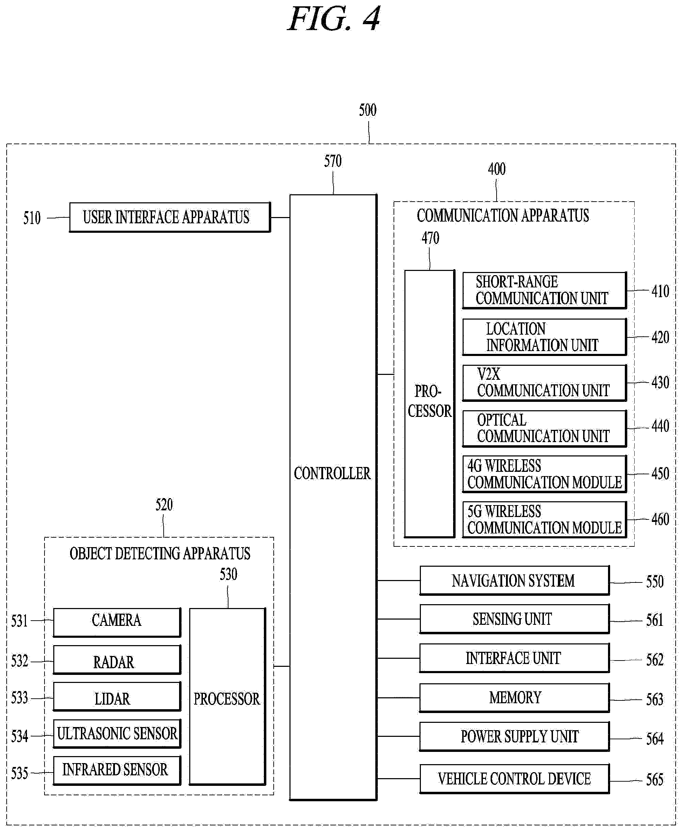

Meanwhile, FIG. 4 is a block diagram illustrating a vehicle and an antenna system mounted on the vehicle in accordance with an implementation.

The vehicle 500 may be an autonomous (driving) vehicle. The vehicle 500 may be switched into an autonomous driving mode or a manual mode (a pseudo driving mode) based on a user input. For example, the vehicle 500 may be switched from the manual mode into the autonomous mode or from the autonomous mode into the manual mode based on a user input received through a user interface apparatus 510.

In relation to the manual mode and the autonomous driving mode, operations such as object detection, wireless communication, navigation, and operations of vehicle sensors and interfaces may be performed by the telematics control unit mounted on the vehicle 500. Specifically, the telematics control unit mounted on the vehicle 500 may perform the operations in cooperation with the antenna module 300, the object detecting apparatus 520, and other interfaces. In some examples, the communication apparatus 400 may be disposed in the telematics control unit separately from the antenna system 300 or may be disposed in the antenna system 300.

The vehicle 500 may be switched into the autonomous mode or the manual mode based on driving environment information. The driving environment information may be generated based on object information provided by the object detecting apparatus 520. For example, the vehicle 500 may be switched from the manual mode into the autonomous driving mode or from the autonomous driving mode into the manual mode based on driving environment information generated in the object detecting apparatus 520.

For example, the vehicle 500 may be switched from the manual mode into the autonomous driving mode or from the autonomous driving mode into the manual mode based on driving environment information received through the communication apparatus 400. The vehicle 500 may be switched from the manual mode into the autonomous driving mode or from the autonomous driving mode into the manual mode based on information, data or signal provided by an external device.

When the vehicle 500 travels in the autonomous mode, the autonomous vehicle 500 may travel under the control of an operation system. For example, the autonomous vehicle 500 may travel based on information, data or signal generated in a driving system, a parking exit (parking-lot leaving) system, and a parking system. When the vehicle 500 is driven in the manual mode, the autonomous vehicle 500 may receive a user input for driving through a driving control apparatus. The vehicle 500 may travel based on the user input received through the driving control apparatus.

The vehicle 500 may include a user interface apparatus 510, an object detecting apparatus 520, a navigation system 550, and a communication apparatus 400. The vehicle may further include a sensing unit 561, an interface unit 562, a memory 563, a power supply unit 564, and a vehicle control device 565 in addition to the aforementioned apparatuses and devices. In some implementations, the vehicle 500 may include more components in addition to components to be explained herein or may not include some of those components to be explained herein.

The user interface apparatus 510 may be an apparatus for communication between the vehicle 500 and a user. The user interface apparatus 510 may receive a user input and provide information generated in the vehicle 500 to the user. The vehicle 500 may implement user interfaces (Uls) or user experiences (UXs) through the user interface apparatus 510.

The object detecting apparatus 520 may be a device for detecting an object located at outside of the vehicle 500. The object may be a variety of things associated with driving (operation) of the vehicle 500. In some examples, objects may be classified into moving objects and fixed (stationary) objects. For example, the moving objects may include other vehicles and pedestrians. The fixed objects may conceptually include traffic signals, roads, and structures, for example. The object detecting apparatus 520 may include a camera 521, a radar 522, a LiDAR 523, an ultrasonic sensor 524, an infrared sensor 525, and a processor 530. In some implementations, the object detecting apparatus 520 may further include other components in addition to the components described, or may not include some of the components described.

The processor 530 may control an overall operation of each unit of the object detecting apparatus 520. The processor 530 may detect an object based on an acquired image, and track the object. The processor 530 may execute operations, such as computing of a distance to the object, computing of a relative speed with respect to the object and the like, through an image processing algorithm.

According to an embodiment, the object detecting apparatus 520 may include a plurality of processors 530 or may not include any processor 530. For example, each of the camera 521, the radar 522, the LiDAR 523, the ultrasonic sensor 524 and the infrared sensor 525 may include the processor in an individual manner.

When the processor 530 is not included in the object detecting apparatus 520, the object detecting apparatus 520 may operate according to the control of a processor of an apparatus within the vehicle 500 or the controller 570.

The navigation system 550 may provide location information related to the vehicle based on information obtained through the communication apparatus 400, in particular, a location information unit 420. Also, the navigation system 550 may provide a path (or route) guidance service to a destination based on current location information related to the vehicle. In addition, the navigation system 550 may provide guidance information related to surroundings of the vehicle based on information obtained through the object detecting apparatus 520 and/or a V2X communication unit 430. In some examples, guidance information, autonomous driving service, etc. may be provided based on V2V, V2I, and V2X information obtained through a wireless communication unit operating together with the antenna system 1000.

The communication apparatus 400 may be an apparatus for performing communication with an external device. Here, the external device may be another vehicle, a mobile terminal, or a server. The communication apparatus 400 may perform the communication by including at least one of a transmitting antenna, a receiving antenna, and radio frequency (RF) circuit and RF device for implementing various communication protocols. The communication apparatus 400 may include a short-range communication unit 410, a location information unit 420, a V2X communication unit 430, an optical communication unit 440, a 4G wireless communication module 450, and a processor 470. According to an embodiment, the communication apparatus 400 may further include other components in addition to the components described, or may not include some of the components described.

The short-range communication unit 410 is a unit for facilitating short-range communications. The short-range communication unit 410 may construct short-range wireless area networks to perform short-range communication between the vehicle 500 and at least one external device. The location information unit 420 may be a unit for acquiring location information related to the vehicle 500. For example, the location information unit 420 may include a Global Positioning System (GPS) module or a Differential Global Positioning System (DGPS) module.

The V2X communication unit 430 may be a unit for performing wireless communication with a server (Vehicle to Infrastructure; V2I), another vehicle (Vehicle to Vehicle; V2V), or a pedestrian (Vehicle to Pedestrian; V2P). The V2X communication unit 430 may include an RF circuit in which protocols for communication with an infrastructure (V2I), communication between vehicles (V2V), and communication with a pedestrian (V2P) are executable. The optical communication unit 440 may be a unit for performing communication with an external device through the medium of light. The optical communication unit 440 may include an optical transmission part for converting an electric signal into an optical signal and transmitting the optical signal to the outside, and an optical reception part for converting the received optical signal into the electric signal. According to an embodiment, the optical transmission part may be formed integrally with lamps provided on the vehicle 500.

The wireless communication unit 460 is a unit that performs wireless communication with one or more communication systems through one or more antenna systems. The wireless communication unit 460 may transmit and/or receive a signal to and/or from a device in a first communication system through a first antenna system. In addition, the wireless communication unit may transmit and/or receive a signal to and/or from a device in a second communication system through a second antenna system. For example, the first communication system and the second communication system may be an LTE communication system and a 5G communication system, respectively. However, the first communication system and the second communication system may not be limited thereto, and may be changed according to applications.

In some examples, the antenna module 300 disposed in the vehicle 500 may include a wireless communication unit. In this regard, the vehicle 500 may be an electric vehicle (EV) or a vehicle that can be connected to a communication system independently of an external electronic device. In this regard, the communication apparatus 400 may include at least one of the short-range communication unit 410, the location information unit 420, the V2X communication unit 430, the optical communication unit 440, a 4G wireless communication module 450, and a 5G wireless communication module 460.

The 4G wireless communication module 450 may perform transmission and reception of 4G signals with a 4G base station through a 4G mobile communication network. In this case, the 4G wireless communication module 450 may transmit at least one 4G transmission signal to the 4G base station. In addition, the 4G wireless communication module 450 may receive at least one 4G reception signal from the 4G base station. In this regard, uplink (UL) multi-input multi-output (MIMO) may be performed by a plurality of 4G transmission signals transmitted to the 4G base station. In addition, downlink (DL) MIMO may be performed by a plurality of 4G reception signals received from the 4G base station.

The 5G wireless communication module 460 may perform transmission and reception of 5G signals with a 5G base station through a 5G mobile communication network. Here, the 4G base station and the 5G base station may have a Non-Stand-Alone (NSA) architecture. For instance, the 4G base station and the 5G base station may have a Non-Stand-Alone (NSA) architecture. Alternatively, the 5G base station may be disposed in a Stand-Alone (SA) structure at a separate location from the 4G base station. The 5G wireless communication module 460 may perform transmission and reception of 5G signals with a 5G base station through a 5G mobile communication network. In this case, the 5G wireless communication module 460 may transmit at least one 5G transmission signal to the 5G base station. In addition, the 5G wireless communication module 460 may receive at least one 5G reception signal from the 5G base station. In this instance, 5G and 4G networks may use the same frequency band, and this may be referred to as LTE re-farming. In some examples, a sub-6 frequency band, which is a range of 6 GHz or less, may be used as the 5G frequency band. On the other hand, a millimeter-wave (mmWave) range may be used as the 5G frequency band to perform wideband high-speed communication. When the mmWave band is used, the electronic device may perform beamforming for coverage expansion of an area where communication with a base station is possible.

On the other hand, regardless of the 5G frequency band, 5G communication systems can support a larger number of multi-input multi-output (MIMO) to improve a transmission rate. In this instance, UL MIMO may be performed by a plurality of 5G transmission signals transmitted to a 5G base station. In addition, DL MIMO may be performed by a plurality of 5G reception signals received from the 5G base station.

In some examples, the wireless communication unit 110 may be in a Dual Connectivity (DC) state with the 4G base station and the 5G base station through the 4G wireless communication module 450 and the 5G wireless communication module 460. As such, the dual connectivity to the 4G base station and the 5G base station may be referred to as EUTRAN NR DC (EN-DC). When the 4G base station and 5G base station are disposed in a co-located structure, throughput improvement may be achieved by inter-Carrier Aggregation (inter-CA). Therefore, when the 4G base station and the 5G base station are disposed in the EN-DC state, the 4G reception signal and the 5G reception signal may be simultaneously received through the 4G wireless communication module 450 and the 5G wireless communication module 460, respectively. Short-range communication between electronic devices (e.g., vehicles) may be performed using the 4G wireless communication module 450 and the 5G wireless communication module 460. In one embodiment, after resources are allocated, vehicles may perform wireless communication in a V2V manner without a base station.

Meanwhile, for transmission speed improvement and communication system convergence, carrier aggregation (CA) using at least one of the 4G wireless communication module 450 and 5G wireless communication module 460 and the Wi-Fi communication module 113. In this regard, 4G + WiFi carrier aggregation (CA) may be performed using the 4G wireless communication module 450 and the Wi-Fi communication module 113. Or, 5G + WiFi CA may be performed using the 5G wireless communication module 460 and the Wi-Fi communication module.

In some examples, the communication apparatus 400 may implement a display apparatus for a vehicle together with the user interface apparatus 510. In this instance, the display apparatus for the vehicle may be referred to as a telematics apparatus or an Audio Video Navigation (AVN) apparatus.

The processor 470 of the communication apparatus 400 may correspond to a modem. In this regard, the RFIC and the modem may be referred to as a first controller (or a first processor) and a second controller (a second processor), respectively. Meanwhile, the RFIC and the modem may be implemented as physically separate circuits. Alternatively, the RFIC and the modem may be logically or functionally distinguished from each other on one physical circuit. The modem may perform control and signal processing for the transmission and reception of signals through different communication systems through the RFIC. The modem 1400 may be acquired through control information received from the 4G base station and/or the 5G base station. Here, the control information may be received through a physical downlink control channel (PDCCH), but the present disclosure is not limited thereto.

The modem may control the RFIC 1250 to transmit and/or receive signals through the first communication system and/or the second communication system for a specific time interval and from frequency resources. Accordingly, the vehicle can be allocated resources or maintain a connected state through the eNB or gNB. In addition, the vehicle may perform at least one of V2V communication, V2I communication, and V2P communication with other entities using the allocated resources.

Meanwhile, referring to FIGS. 1A to 4, the antenna module mounted on the vehicle may be disposed inside the vehicle, on the roof of the vehicle, inside the roof, or inside the roof frame. In this regard, the antenna system disclosed herein may be configured to operate in a low band (LB), mid band (MB), and high band (HB) of a 4G LTE system and a sub-6 band of a 5G NR system.

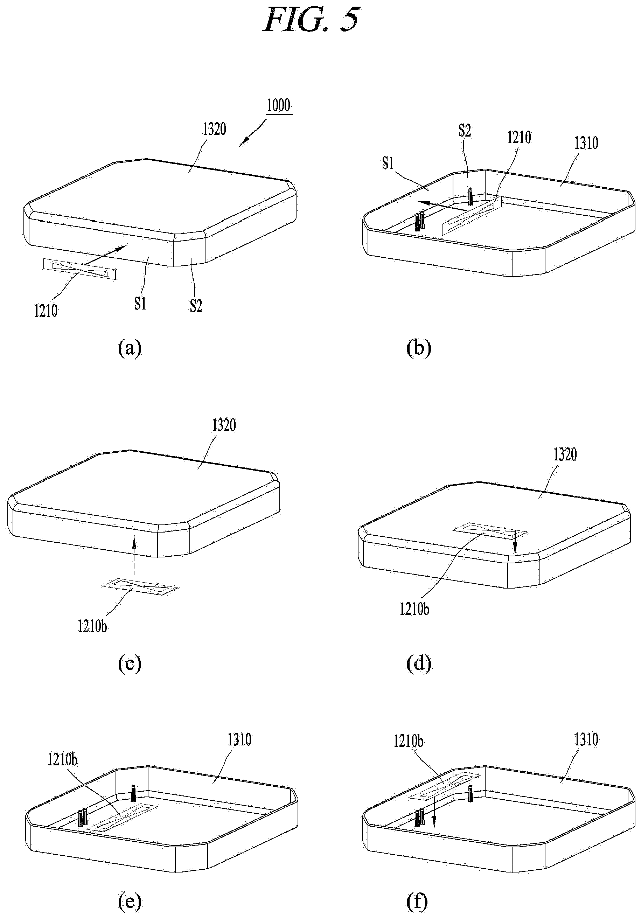

Hereinafter, a wideband antenna element and a vehicle antenna module including the antenna element according to this specification will be described. In this regard, FIG. 5 shows various configurations in which an antenna element is disposed in an upper region, a side region, and a lower region of a top cover in an antenna module.

Referring to (a) to (f) of FIG. 5, an antenna system mounted on a vehicle may be implemented in the form of an antenna module 1000. Referring to (a) and (b) of FIG. 5, an antenna element 1210 is disposed in a side region of a top cover 1320 of the antenna module 100 to radiate a wireless signal to the side region of the top cover 1320. (a) of FIG. 5 shows a structure in which the antenna element 1210 is attached to the side region of the top cover 1320 to radiate a wireless signal to the side region of the top cover 1320. (b) of FIG. 5 shows a structure in which the antenna element 1210 is attached to a side region of a bottom cover 1310. (b) of FIG. 5 shows a structure in which the antenna element 1210 is attached to the side region of the bottom cover 1310 to radiate a wireless signal to the side region of the top cover 1320 in (a) of FIG. 5.

Referring to (c) and (d) of FIG. 5, an antenna element 1210b is disposed in a front region of the top cover 1320 of the antenna module 100 to radiate a wireless signal to the front region of the top cover 1320. (c) of FIG. 5 shows a structure in which the antenna element 1210b is attached to an inner region of the front region of the top cover 1320 to radiate a wireless signal to the front region of the top cover 1320. (d) of FIG. 5 shows a structure in which the antenna element 1210 is attached to an outer region of the front region of the top cover 1320 to radiate a wireless signal to the front region of the top cover 1320.

Referring to (e) and (f) of FIG. 5, the antenna element 1210b is disposed in parallel to the bottom cover 1310 of the antenna module 100 to radiate a wireless signal to the front region of the top cover 1320. (e) of FIG. 5 shows a structure in which the antenna element 1210b is attached to an inner region of the bottom cover 1310 to radiate a wireless signal to the front region of the top cover 1320. (f) of FIG. 5 shows a structure that the antenna element 1210b is disposed at a predetermined distance from the bottom cover 1310 to radiate a wireless signal to the front region of the top cover 1320.

Referring to (a) and (b) of FIG. 5, the antenna element 1210 may be disposed on the side region of the top cover 1320 of the antenna module 100. Referring to (c) and (d) of FIG. 5, the antenna element 1210b may be disposed on in the front region (upper region) of the top cover 1320 of the antenna module 100.

The antenna element 1210 may be a wideband antenna operating in a low band (LB) for 4G/5G communication. The antenna element 1210 may be configured to improve antenna performance in a band of approximately 600 to 700 MHz. The antenna element 1210 may be configured to operate as a radiator throughout an LB band of about 600 to 960 MHz, including the band of 600 to 700 MHz. Furthermore, in addition to the antenna element 1210, a separate antenna element disposed within the antenna module 100 may be configured to provide a communication service at 2.5 to 5 GHz through the antenna module 100.

The antenna element 1210 may be a slot radiator configured to radiate a wireless signal through a slot region SR disposed on a metal plate 1321, 1322 and a portion of the top cover 1320, but is not limited thereto. The antenna element 1210 may be a bow-tie slot antenna element in which a slot region SR is disposed in a bow-tie slot structure on the metal plate 1321, but is not limited thereto.

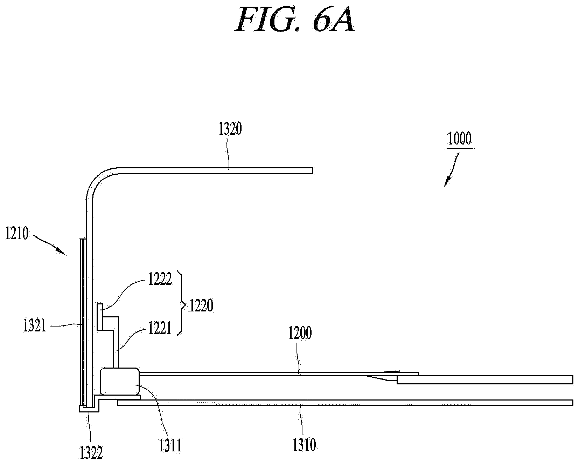

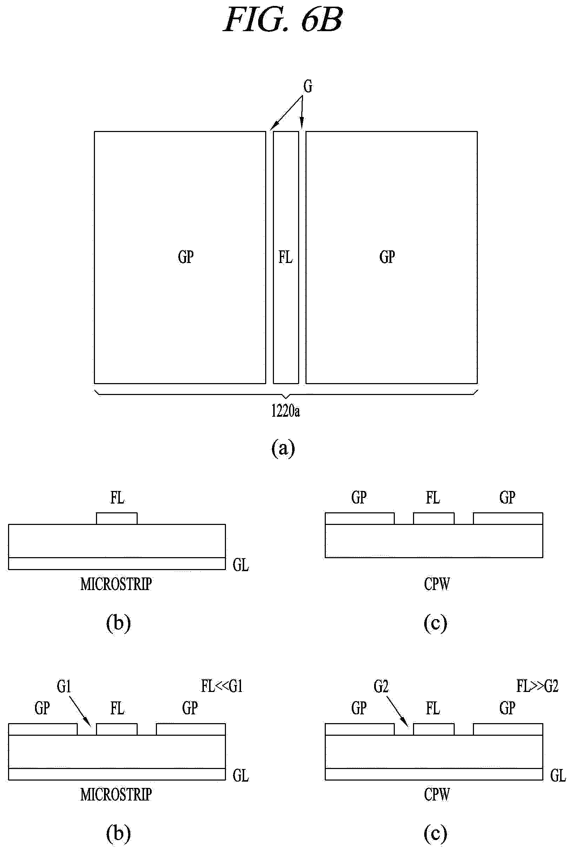

Referring to FIGS. 6A and 6B, the metal plate 1321, 1322 may be formed using an injection method to be attached to a partial region of the top cover 1320 of the antenna module 1000. As shown in FIG. 6A, the metal plate 1321 may be formed using an injection method to be attached to the side region of the top cover 1320. As shown in FIG. 6A, the metal plate 1322 may be formed using an injection method to be attached to the front region of the top cover 1320.

FIG. 6A shows a side view of a configuration in which an antenna element according to this specification is disposed in a side region of a top cover in an antenna module consisting of a top cover and a bottom cover. FIG. 6B shows a transmission line configured to feed an antenna element according to this specification.

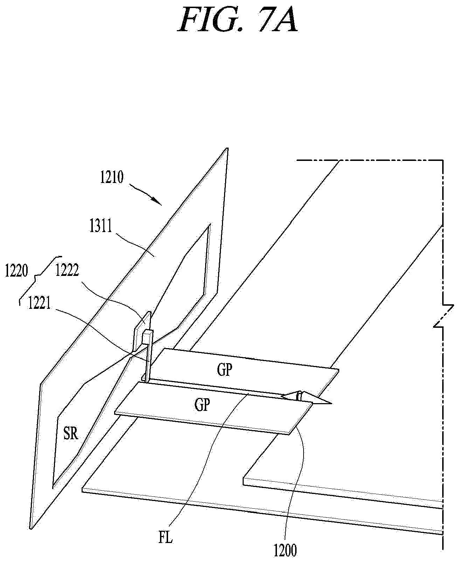

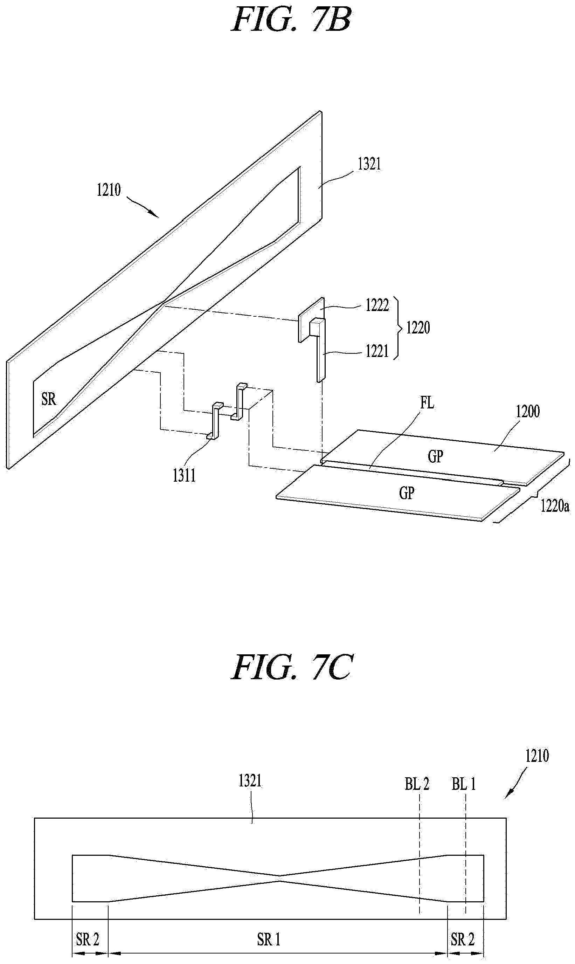

Meanwhile, FIG. 7A shows a configuration in which a transmission line and an antenna element implemented on a PCB disposed in a bottom cover of the antenna module are coupled to each other. FIG. 7B shows an exploded state of the antenna element that can be coupled to the transmission line implemented on the PCB of FIG. 7A prior to being coupled to each other. FIG. 7C is a front view of a slot radiator of FIGS. 7A and 7B, which is seen from a front side thereof. Referring to FIGS. 6A to 7C, a main feature of this specification is 1) an antenna structure for a low band (LB) operation by applying a bow-tie structure to a metal region of the cover of the antenna module. Furthermore, the main feature is 2) a structure in which a metal planar patch with a slot applied to an injection case is attached to the cover of the antenna module. In addition, the main feature is 3) a CPW feed structure that allows the antenna to operate in a patch mode and a slot mode so as to implement a wideband characteristic.

Referring to FIG. 6A, the antenna module 1000 mounted on a vehicle may include a bottom cover 1310 and a top cover 1320.

A printed circuit board (PCB) 1200 may be configured such that an antenna element 1210 and electronic components are disposed thereon. The bottom cover 1310 may be disposed below the PCB 1200 and configured with the metal plate 1321 having the slot region SR disposed in a region corresponding to a region where the antenna element 1210 is disposed. The top cover 1320 may be fastened to the bottom cover 1310 to accommodate the PCB 1200 therein. A wideband antenna according to this specification may be configured with the antenna element 1210 in which the metal plate 1321 in which the slot region SR is disposed operates as a radiator.

Meanwhile, the antenna element 1210 may be disposed in a space between the bottom cover 1310 and the top cover 1320 so as to be mounted as the antenna module 1000 outside or inside the vehicle roof, as shown in FIGS. 3A to 3C. The bottom cover 1310 and the top cover 1320 may constitute a cover 1300 that forms an exterior of the antenna system, and components including the antenna element 1210 disposed within the cover 1300 may be disposed inside the vehicle roof.

With reference to FIGS. 5A to 7B, the antenna module 1000 mounted on a vehicle will be described. A transmission line 1201 may be disposed on the PCB 1200. The transmission line 1220a may be a co-planar waveguide (CPW) transmission line with ground patterns GPs disposed on both sides of the same substrate as the feed line FL, but is not limited thereto.

In this regard, referring to (a) of FIG. 6B, the CPW transmission line 1220a may have a ground pattern GP disposed on both sides of the same substrate as the feed line FL. The feed line FL and ground pattern GP may be disposed as a metal pattern. A region between the feed line FL and the ground pattern GP may be disposed as a dielectric region. Accordingly, the region between the feed line FL and the ground pattern GP corresponds to a gap (G) region from which the metal pattern has been removed.

Referring to (a) of FIG. 6B, compared to a microstrip line structure, in the CPW structure, a width of a central metal line, that is, the feed line FL, is larger than a distance of the gap (G) between the feed line FL and the ground pattern GP. The CPW transmission line 1220a as shown in (a) of FIG. 6B is a structure suitable for feeding an antenna structure such as a slot radiator 1210. In other words, the CPW transmission line 1220a has stable characteristics capable of transmitting RF signals with low loss in a high frequency band due to the ground patterns GPs disposed adjacent to the feed line FL.

(b) and (c) of FIG. 6B show side views of a first transmission line having a microstrip line type and a second transmission line having a CPW type. Referring to (b) of FIG. 6B, the first transmission line is disposed with the feed line FL in an upper layer of a dielectric substrate, and a ground layer GL in a lower layer thereof. Referring to (c) of FIG. 6B, the second transmission line is disposed with the feed line FL in an upper layer of the dielectric substrate, and ground patterns GPs on both sides of the feed line FL.

(d) of FIG. 6B shows a metal pattern disposed on a side of the feed line FL in the microstrip line structure in (b) of FIG. 6B. (e) of FIG. 6B shows a ground layer disposed below the feed line FL in the CPW transmission line structure in (c) of FIG. 6B. In the microstrip line structure in (d) of FIG. 6B, a distance of a first gap (G) is larger than a width of the feed line FL. On the contrary, in the CPW transmission line structure in (e) of FIG. 6B, a distance of a second gap (G) is smaller than the width of the feed line FL.

Meanwhile, the antenna module 1000 according to this specification may be configured with the bottom cover 1310 in which the PCB 1200 is disposed. In this regard, as shown in FIG. 6A, the PCB 1200 and the bottom cover 1310 may be coupled by means of a contact portion 1311, but the present disclosure is not limited thereto. As another example, the ground of the PCB 1200 may be disposed in contact with a top of the bottom cover 1310.

The top cover 1320 may be configured to be fastened to the bottom cover 1310 to accommodate the PCB 1200 therein, and to have a metal plate 1321 disposed in a partial region made of a dielectric. The bottom cover 1310 may be configured such that a portion of the bottom cover 1310 surrounds a bottom side portion of a mechanism of the top cover 1320.

In this regard, the bottom cover 1310 may be formed of a metal material to discharge heat generated within the antenna module 100 to the outside. The bottom cover 1310 may be configured with a heat sink to enable heat dissipation. Accordingly, the bottom cover 1310 may be connected to the metal plate 1321 of the top cover 1320, and the bottom cover 1310 may be connected to the ground. The metal plate 1321 of the bottom cover 1310 and the top cover 1320 may be electrically connected to the ground of the PCB 1200. Therefore, mechanical stability is ensured by a coupling structure 1312 between the bottom cover 1310 and the top cover 1320, and the metal plate 1321 operates as a ground, so that the slot radiator 1210 operates as an antenna.

Referring to FIGS. 7A and 7B, coupling structures 1311, 1312 may be disposed to couple between the PCB 1200 and the top cover 1320 having the metal plate 1321 disposed therein. The coupling structure 1312 may be configured to fasten between the bottom cover 1310 and the top cover 1320. The coupling structures 1311, 1312 allow the metal plate 1321 in a side region of the top cover 1320 to be electrically connected to the PCB 1200. A portion of the coupling structures 1311, 1312 may be coupled to the mechanical structure of the top cover 1320 and connected to the PCB 1200. The coupling structures 1311, 1312 may be integrally formed. Only one of the coupling structures 1311, 1312 may be implemented, and the other one may be optionally implemented.

The antenna element 1210 may be implemented as a slot radiator 1210. The slot radiator 1210 may be configured to radiate a wireless signal through the slot region SR disposed on the metal plate 1321 and a partial region of the top cover 1320. A feeding structure 1220 is configured to radiate a wireless signal of the transmission line 1220a disposed on the PCB 1200 through the slot radiator 1210. The feeding structure 1220 is configured to transmit a wireless signal to the slot radiator 1210.

The feeding structure 1220 may include a first connection portion 1221 and a second connection portion 1222. The first connection portion 1221 is connected in perpendicular to the signal line of the CPW transmission line 1220a disposed on the PCB 1200. The first connection portion 1221 extends in a height direction (y-axis direction) of the PCB 1200 to a point higher than the center point of the slot region SR such that the wireless signal is coupled to the slot region SR. The first connection portion 1221 may be disposed to have a first width and a first length.

The second connection portion 1222 is disposed to have a predetermined length, that is, a second length, at a point higher than the center point of the slot region SR. The second connection portion 1222 may be disposed to have a second width and a second length. The second connection portion 1222 may be configured to be spaced apart from the metal plate 1321 by a predetermined distance at a point higher than the center point of the slot region SR. That is, the second connection portion 1222 may be disposed adjacent to the metal plate 1321 in a z-axis direction than the first connection portion 1221. In this regard, the metal plate 1321 may be attached to an outside of the side region of the top cover 1320, and the second connection portion 1222 may be attached to an inside of the side region of the top cover 1320. Accordingly, the second connection portion 1222 and the metal plate 1321 may be spaced apart by a thickness of the side region of the top cover 1320 for mutual wireless signal coupling.

A second distance between the second connection portion 1222 and the metal plate 1322 may be set to be smaller than a first distance between the first connection portion 1221 and the metal plate 1321. Accordingly, the second connection portion 1222 may be disposed more adjacent to the metal plate 1321 than the first connection portion 1221.

The first connection portion 1221 is configured with a first width and a first length to ensure impedance matching between the transmission line and the slot radiator 1210 when a wireless signal is applied to the slot region SR. Meanwhile, the second connection portion 1222 may be configured with a second width larger than the first width and a second length smaller than the first length.

Referring to FIG. 7C, the slot radiator 1210 is disposed to have a first length in a first axis, that is, an x-axis direction, with respect to the center point of the slot region SR. Meanwhile, the slot radiator 1210 may be configured to gradually increase in width in a second axis, that is, a y-axis direction, with respect to the center point of the slot region SR.

Referring to FIG. 7C, the slot region SR may include a first region SR1 and a second region SR2 in the second axis, that is, the y-axis direction. The first region SR1 may be disposed in a tapering structure to gradually increase in width in the second axis direction with respect to the center point that is coupling-fed by the feeding structure 1220. The second region SR2 may be disposed in a structure having a constant width in the second axis direction. The metal plate 1310 on which the slot radiator 1210 is disposed may be disposed in a bendable structure. Accordingly, the metal plate 1310 having the slot radiator 1210 disposed thereon may be disposed on a flexible substrate such as an FPCB.

Accordingly, the slot radiator 1210 may be configured in a flexible shape. The slot radiator 1210 may be bent at a predetermined point so as to be disposed on different sides of the top cover 1320. In this regard, the first region SR1 of the slot regions SR may be disposed in a first side region of the top cover 1320, and at least part of the second region SR2 may be disposed in the second side region adjacent to the first side region. At least part of the second region SR2 may be disposed in a second side region with respect to a first bending line BL1.

Meanwhile, the first region SR1 may be disposed in the first side region of the top cover 1320, and one end portion of the first region R1 and the second region SR2 may be disposed in the second side region adjacent to the first side region. One end portion of the first region R1 and the second region SR2 may be disposed in the second side region with respect to a second bending line BL2. In this regard, the first side region and the second side region may be a first side region S1 and a second side region S2 adjacent to the first side region S1 in (a) and (b) of FIG. 5. Accordingly, when different slot radiators are disposed on the sides of the bottom cover 1310 and the top cover 1320, a separation distance between the slot radiators may be secured to improve mutual isolation.

The feeding structure 1220 that is coupled to the metal plate 1321 having a bow-tie slot region SR in a shape of crossing the slot region SR may be disposed. By the feeding structure 1220 that is coupled to the slot region SR in the shape of crossing the bow-tie slot region SR, the slot radiator 1210 is combined into two modes, a slot mode and a patch mode, so that the slot radiator 1210 operates as a wideband antenna.

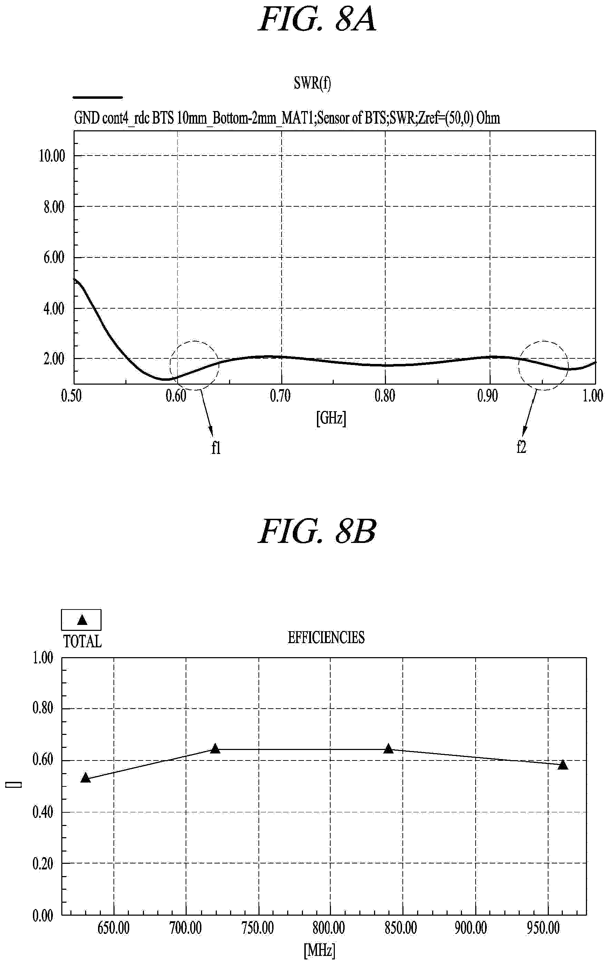

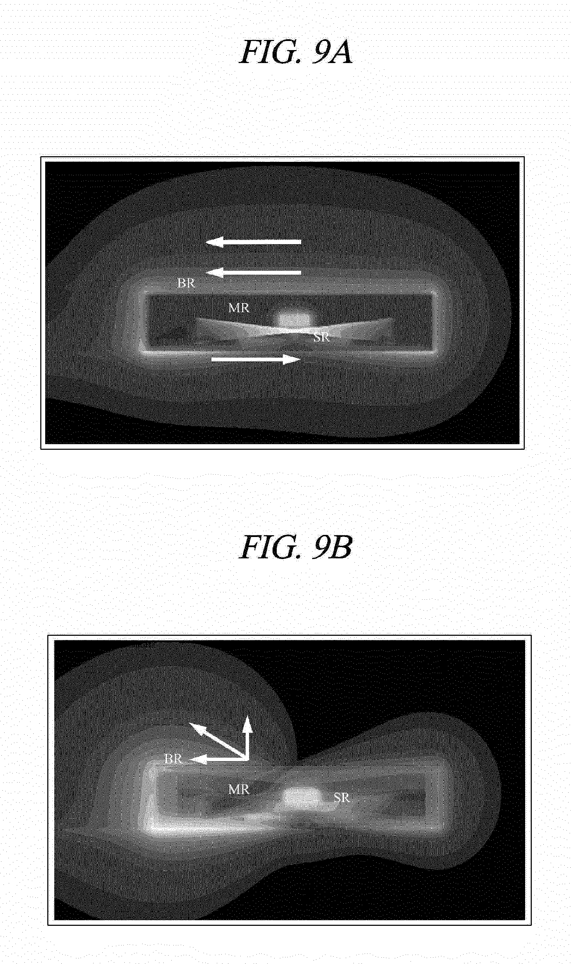

In this regard, FIGS. 8A and 8B show a VSWR and an antenna efficiency of a wideband antenna element presented herein. Meanwhile, FIGS. 9A and 9B show electric field distributions at first and second frequencies of a wideband antenna element presented herein.

Referring to FIGS. 7 and 8A, the antenna element 1210 has a double resonance characteristic at a first frequency, which is a low frequency, and a second frequency, which is a high frequency, within the LB. The antenna element 1210 has a voltage standing wave ratio (VSWR) value below 2 over an entire LB band. In addition, referring to a VSWR simulation result of FIG. 8A, the antenna element 1210 has low VSWR values at the first and second frequencies within the LB and therefore has a double resonance characteristic at the first and second frequencies.

In this regard, at the first frequency the antenna element 1210 operates in a first mode (slot mode). On the contrary, at the second frequency, the antenna element 1210 operates in a second mode (patch mode). As an example, the first frequency and the second frequency may be about 620 MHz and 950 MHz, but are not limited thereto. Accordingly, the antenna element 1210 may operate as a wideband antenna over the entire LB band by combining the first mode (slot mode) and the second mode (patch mode).

Referring to FIGS. 7 and 8B, the antenna efficiency of the antenna element 1210 over the entire LB band has a high efficiency of above 60%. Referring to FIG. 8B, it has an antenna gain of above -3.9 dB at each frequency of 620 MHz to 960 MHz. In this regard, the antenna gain value is measured in a low elevation angle range of about 60 to 90 degrees based on a boresight, which is a vertical direction of the antenna element, and about 0 to 30 degrees with respect to a horizontal direction thereof. Therefore, referring to FIGS. 7 to 8B, considering VSWR characteristics and antenna efficiency characteristics, the antenna element 1210 operates as a wideband antenna over the entire LB band.

Referring to FIGS. 7 and 9A, an E-field is formed to be highest in the slot region SR at 620 MHz, so the antenna element 1210 operates in the first mode (slot mode). In this regard, the E-field has a low value in a metal region MR between the slot region SR and a boundary region of the metal plate 1311. Additionally, in the boundary region BR of the metal plate 1311 where the E-field is formed to be high along with the slot region SR, the E-field exhibits a large horizontal component in parallel to the boundary region BR. That is, in the boundary region BR of the metal plate 1311, the horizontal component of the E-field is dominant over the vertical component of the E-field, and thus operates in the first mode (slot mode) at the first frequency.

Referring to FIGS. 7 and 9B, an E-field distribution is formed to be highest in the boundary region BR of the metal plate 1311 at 950 MHz, and the antenna element 1210 operates in the second mode (patch mode). In this regard, the E-field in the metal region MR between the slot region SR and the boundary region of the metal plate 1311 has a higher value than that in the metal region of FIG. 9A. Additionally, in the boundary region BR of the metal plate 1311 where the E-field is formed to be high, the E-field exhibits both a horizontal component in parallel to the boundary region BR and a horizontal component perpendicular to the boundary region BR. That is, both the horizontal and vertical components of the E-field is present in the boundary region BR of the metal plate 1311, and thus operates in the second mode (patch mode) at the second frequency.

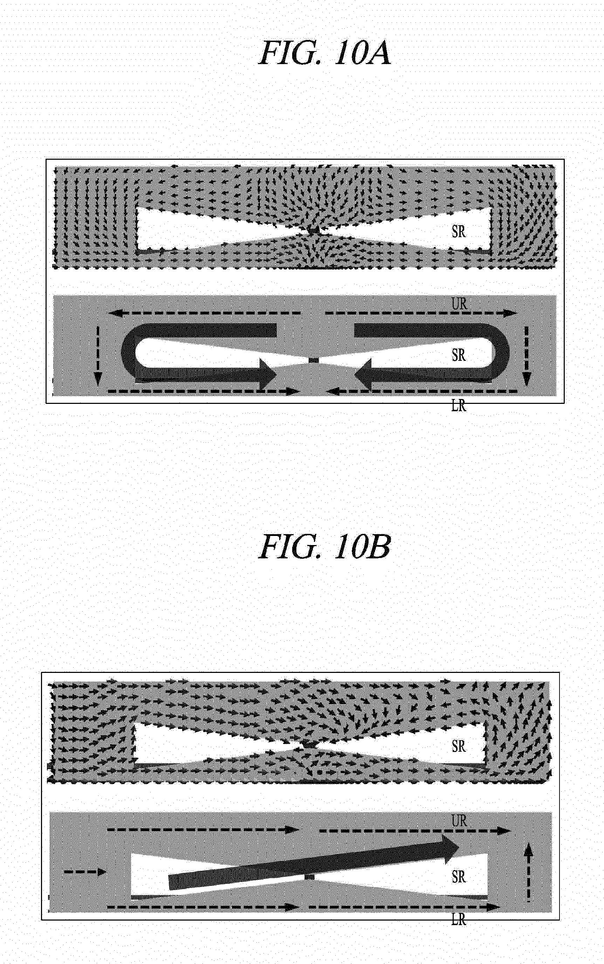

Meanwhile, a current distribution formed on a surface of the wideband antenna element presented herein will be described. In this regard, FIGS. 10A and 10B show current distributions formed on a surface of a wideband antenna element presented herein at first and second frequencies.

As described above, the antenna element 1210 may operate as a wideband antenna over the entire LB band by combining the first mode (slot mode) and the second mode (patch mode) at the first frequency. As an example, the first frequency and the second frequency may be about 620 MHz and 950 MHz, but are not limited thereto. Therefore, a current distribution formed in the antenna element 1210 at the first frequency is formed in the first mode (slot mode). On the contrary, a current distribution formed in the antenna element 1210 at the second frequency is formed in the second mode (patch mode).

Referring to FIGS. 7 and 10A, the antenna element 1210 operates in the first mode (slot mode) at 620 MHz, and equivalent current distributions in the first mode are formed in different directions along the boundary of the slot region SR. As shown in FIGS. 5A and 7, the metal plate 1321 may be disposed in the side region of the top cover 1320.

The slot radiator 1210 may operate in the slot mode at the first frequency in an operating band of the slot radiator. That is, the slot radiator 1210 operates in the slot mode by a current distribution formed to surround the slot region SR at the first frequency. The slot radiator 1210 operates in the slot mode by current distributions formed in different directions in the upper region UR and the lower region LR of the slot region SR. Therefore, in the slot mode, the current distribution of the slot radiator 1210 is formed in a loop shape formed in different directions with respect to the center of the slot region SR.

Referring to FIGS. 7 and 10B, the antenna element 1210 operates in the second mode (patch mode) at 950 MHz, and equivalent current distributions in the second mode are formed in the same direction along the boundary of the slot region SR. As shown in FIGS. 5A and 7, the metal plate 1321 may be disposed in the side region of the top cover 1320.

The slot radiator 1210 may operate in the patch mode at the second frequency in an operating band of the slot radiator. That is, the slot radiator 1210 operates in the patch mode by the current distribution formed in the same direction on the metal plate 1321 at the second frequency. The slot radiator 1210 operates in the patch mode by the current distribution formed in the same direction in the upper region UR and the lower region LR of the slot region SR. Meanwhile, a horizontal current component is dominant in one side direction of the slot region SR, and a vertical current component is dominant in the other side direction of the slot region SR. Therefore, in the patch mode, the current distribution of the slot radiator 1210 is formed at an angle inclined along the boundary of the slot region SR with respect to the center of the slot region SR.

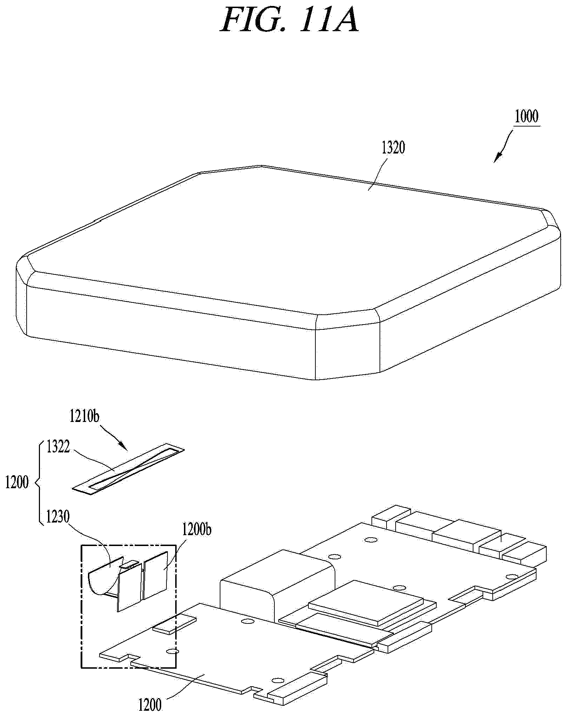

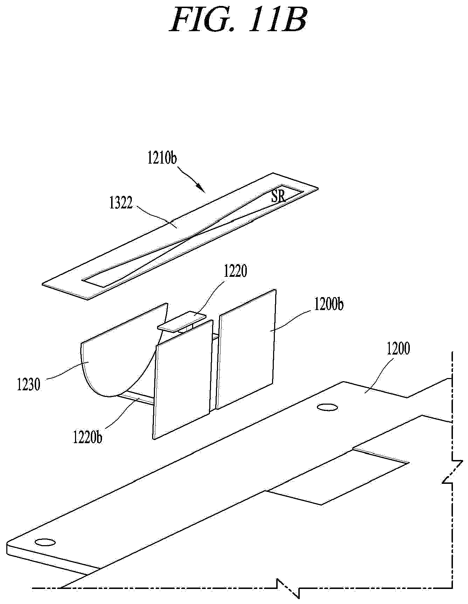

Meanwhile, the wideband antenna element presented herein may be disposed in a front region of the top cover 1320. In this regard, FIG. 11A is an exploded view of an antenna module including a PCB and a radiator module having an antenna element that can be disposed in a front region of a top cover. Meanwhile, FIG. 11B is an enlarged view of the radiator module of FIG. 11A.

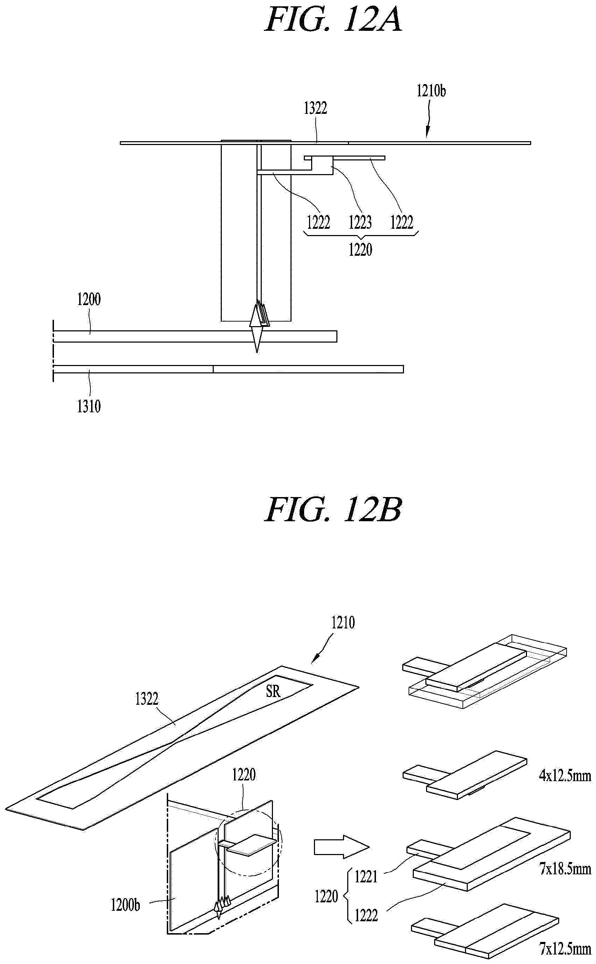

In this regard, FIG. 12A is a side view of an antenna module including the slot radiator of FIG. 11A. In addition, FIG. 12B shows an example of a feeding structure formed in various sizes for feeding a wireless signal to a slot radiator connected to an auxiliary PCB.

Referring to FIGS. 11A and 11B, the metal plate 1322 may be disposed in an inner region of the top cover 1320 to be disposed above the PCB 1200 in parallel to the PCB 1200. The antenna module 1000 may further include an auxiliary PCB 1100b in addition to the PCB 1200 corresponding to a main PCB. The metal plate 1322 may be disposed on the top cover 1320, and a CPW transmission line having ground patterns disposed on both sides of the signal line may be disposed on the auxiliary PCB 1100b. The metal plate 1322 may be coupled to the feeding structure 1220 connected in perpendicular to the signal line of the CPW transmission line to be spaced apart therefrom by a predetermined distance or connected thereto.

The antenna module 1000 may be configured to further include a second radiator 1230 in addition to the slot radiator 1210b. A wireless signal may be applied to the slot radiator 1210b by means of the feeding structure 1220. A wireless signal may be applied to the second radiator 1230 by means of the second feed line 1220b. The second feed line 1220b connected to the second radiator 1230 may be implemented as a signal line of the CPW transmission line on the PCB 1200. Accordingly, the second radiator 1230 may be connected to the signal line of the CPW transmission line and may be disposed perpendicular to the metal plate 1322.

The shape of the second radiator 1230 may be configured to gradually increase in width for a wideband operation. As an example, the shape of the second radiator 1230 may be formed in a semi-circle shape, but is not limited thereto. In this regard, the slot radiator 1210, 1210b may operate in a first band, and the second radiator 1230 may operate in a second band higher than the first band. As an example, the second band may be a mid band (MB) and a high band (HB) associated with 4G/5G communication, but is not limited thereto.

Referring to FIGS. 12A and 12B, the feeding structure 1220 may include a first connection portion 1221 and a second connection portion 1222. The feeding structure 1220 may further include a third connection portion 1223 configured to connect between the first connection portion 1221 and the second connection portion 1222. The first connection portion 1221 may be connected in perpendicular to the signal line of the CPW transmission line. The first connection portion 1221 may extend to a point higher than the center point of the slot region SR in a height direction of the auxiliary PCB 1220b such that a wireless signal is coupled to the slot region SR.

Meanwhile, the second connection portion 1222 is disposed more adjacent to the metal plate 1322 than the first connection portion 1221. That is, a second distance between the second connection portion 1222 and the metal plate 1322 is smaller than a first distance between the first connection portion 1221 and the metal plate 1322. Accordingly, the second connection portion 1222 is disposed more adjacent to the metal plate 1322 than the first connection portion 1221.

The first connection portion 1221 may be configured with a first width and a first length to ensure impedance matching between the transmission line and the slot radiator 1210b when a wireless signal is applied to the slot region SR. The second connection portion 1222 may be configured with a second width larger than the first width and a second length smaller than the first length. Therefore, the first connection portion 1221 having the first width smaller than the second width and the first length larger than the second length operates more similar to a line of the transmission line than the radiator. On the contrary, the second connection portion 1222 having the second width larger than the first width and the second length smaller than the first length operates more similar to the radiator than a line of the transmission line. Therefore, step-by-step impedance matching from the transmission line to the radiator may be achieved according to a transition structure of the transmission line => the first connection portion => the second connection portion => the radiator.

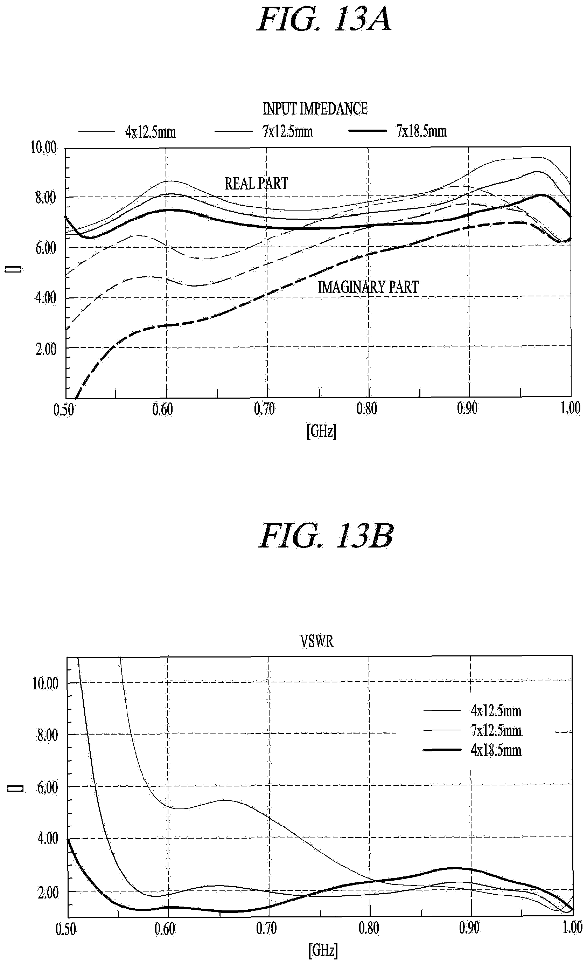

Referring to FIG. 12B, the second width and the second length of the second connection portion 1222 may be adjusted for optimal antenna performance. In this regard, FIGS. 13A and 13B show an antenna input impedance characteristic and a VSWR according to a change in width and length of a second connection portion of a feeding structure.

Referring to FIGS. 12B to 13B, the second width and the second length of the second connection portion 1222 may increase from 4 x 12.5 mm to 7 x 12.5 mm. Meanwhile, the second width and the second length of the second connection portion 1222 may increase from 7 x 12.5 mm to 7 x 18.5 mm. Additionally, both the second width and the second length of the second connection portion 1222 may increase from 4 x 12.5 mm to 7 x 18.5 mm. In this regard, a gap between the second connection portion 1222 and the metal plate 1322 may be set to about 0.5 mm, but is not limited thereto.

Referring to FIG. 13A, a solid line represents a real part of the antenna input impedance and a dotted line represents an imaginary part of the antenna input impedance. Referring to FIGS. 12B and 13A, as a width of the second connection portion 1222 increases from 4 x 12.5mm to 7 x 12.5mm, the real part approaches 50 ohm, thereby improving impedance matching characteristics. Meanwhile, as a length of the second connection portion 1222 increases from 7 x 12.5 mm to 7 x 18.5 mm, a capacitive component of the imaginary part is canceled out, thereby improving impedance matching characteristics.

Therefore, referring to FIGS. 12B to 13B, as the width of the second connection portion 1222 increases from 4 x 12.5 mm to 7 x 12.5 mm, antenna performance is improved in the low band (LB), especially in a band of 600 to 700 MHz. In addition, as the length of the second connection portion 1222 increases from 7 x 12.5 mm to 7 x 18.5 mm, the antenna performance is somewhat degraded within a band above 800MHz in the low band (LB), but the antenna performance is further improved within a band of 600 to 700 MHz. In particular, in order to secure a margin of antenna performance around 600 MHz, the length of the second connection portion 1222 may be further increased, for example, from 12.5 mm to 18.5 mm.

As shown in FIGS. 11A to 12B, when the antenna element 1210b is disposed in a front region of the top cover 1320, it may operate in a larger number of modes than a case where the antenna element 1210 is disposed in a side region of the top cover 1320. Referring to FIGS. 8A to 9B, the antenna element 1210 operates in a first mode (slot mode) and a second mode (patch mode).

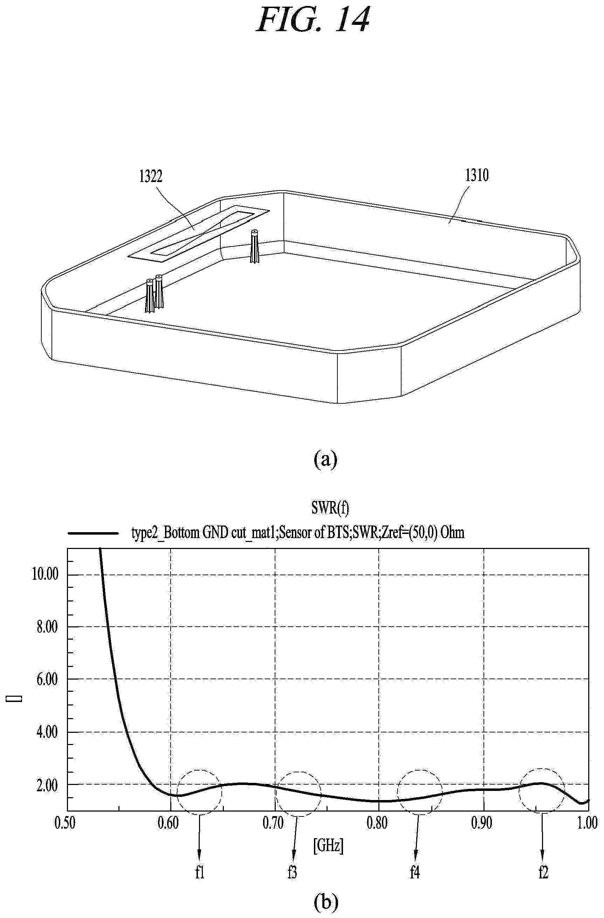

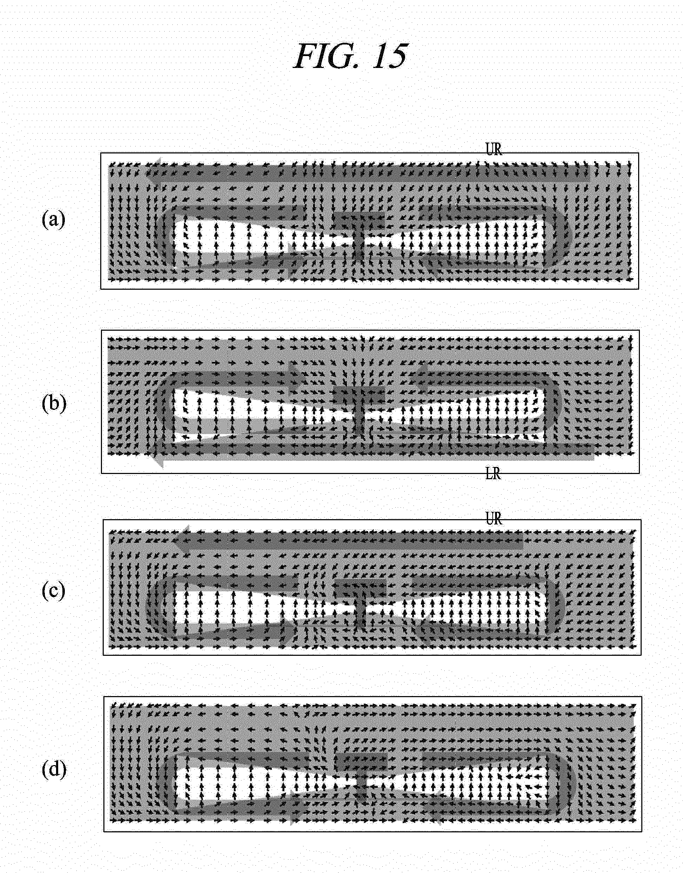

In this regard, FIG. 14 shows a configuration in which an antenna element is disposed in parallel to a bottom cover and a VSWR characteristic of the antenna element according to this configuration. Meanwhile, FIG. 15 shows current distributions formed on a metal plate at different frequencies in a low band (LB).

Referring to (a) of FIG. 14, the metal plate 1322 may be disposed above the bottom cover 1310 in parallel to the bottom cover 1310. Referring to FIGS. 12A, 12B and (a) of FIG. 14, the metal plate 1322 may be disposed in an inner region of the top cover 1320 to be disposed above the PCB 1200 in parallel to the PCB 1200.

Referring to FIGS. 12A, 12B, and (b) of FIG. 14, the slot radiator 1210b corresponding to the antenna element may be configured to have a multi-resonance characteristic at different frequencies within the low band (LB). As an example, the slot radiator 1210b may be configured to resonate in different modes at first to fourth frequencies within the low band (LB).

Referring to FIGS. 12A, 12B, and (a) of FIG. 15, the slot radiator 1210b operates in a first synthesis mode in which the slot mode and the patch mode are synthesized at the first frequency (620 MHz) in an operating band of the slot radiator. Referring to FIGS. 12A, 12B, and (d) of FIG. 15, the slot radiator 1210b operates in the slot mode at the second frequency (950 MHz) higher than the first frequency in the operating band. The slot mode is configured such that current distributions are formed in different directions in the upper region UR and the lower region LR of the slot region SR. The patch mode is configured such that current distributions are formed in the same direction on the metal plate 1322. The patch mode formed at the first frequency (620 MHz) may be formed in only one direction in the upper region UR of the metal plate 1322.

Referring to FIGS. 12A, 12B, and (b) of FIG. 15, the slot radiator 1210b operates in a second synthesis mode in which the slot mode and the patch mode are synthesized at the third frequency (720 MHz) between the first frequency and the second frequency. Referring to FIGS. 12A, 12B, and (c) of FIG. 15, the slot radiator 1210b operates in a first synthesis mode in which the slot mode and the patch mode are synthesized at the fourth frequency (840 MHz) between the third frequency and the second frequency. Accordingly, the slot radiator 1210b operates in the same first synthesis mode at the first frequency (620 MHz) and the fourth frequency (840 MHz).

A direction of the current distribution formed in the slot region SR in the second synthesis mode is formed in a direction opposite to that of the current distribution formed in the slot region SR in the first synthesis mode. Meanwhile, the patch mode formed in the second synthesis mode may be formed in only one direction in the upper region UR of the metal plate 1322. On the contrary, the patch mode formed in the second synthesis mode may be formed only in the other direction in the lower region LR of the metal plate 1322.

Therefore, the slot radiator 1210b disposed in a front region of the top cover 1320 as shown in FIGS. 12A and 12B operates in a larger number of modes than the slot radiator 1210 disposed in a side region of the top cover 1320 as shown in FIG. 7. Accordingly, the slot radiator 1210b disposed in the front region of the top cover 1320 may have better reflection coefficient characteristics and bandwidth characteristics than the slot radiator 1210 disposed on the side region of the top cover 1320.

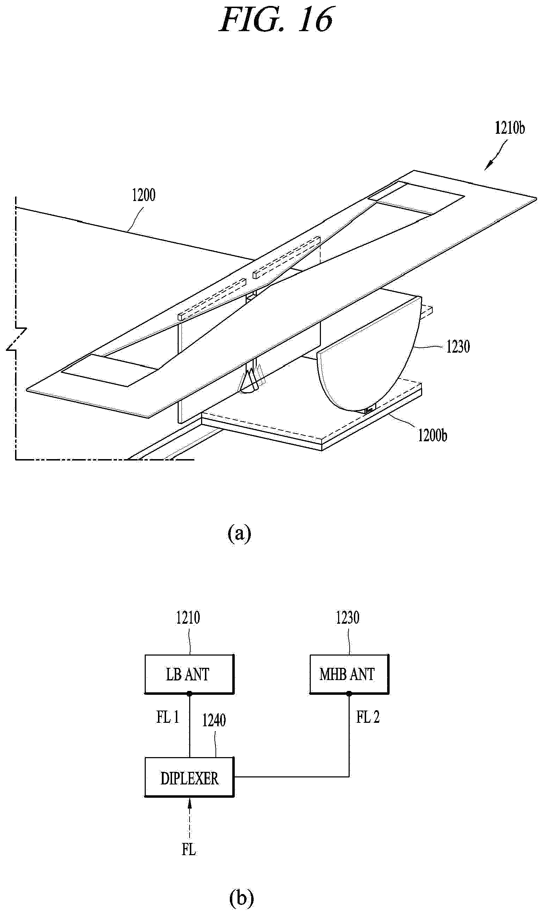

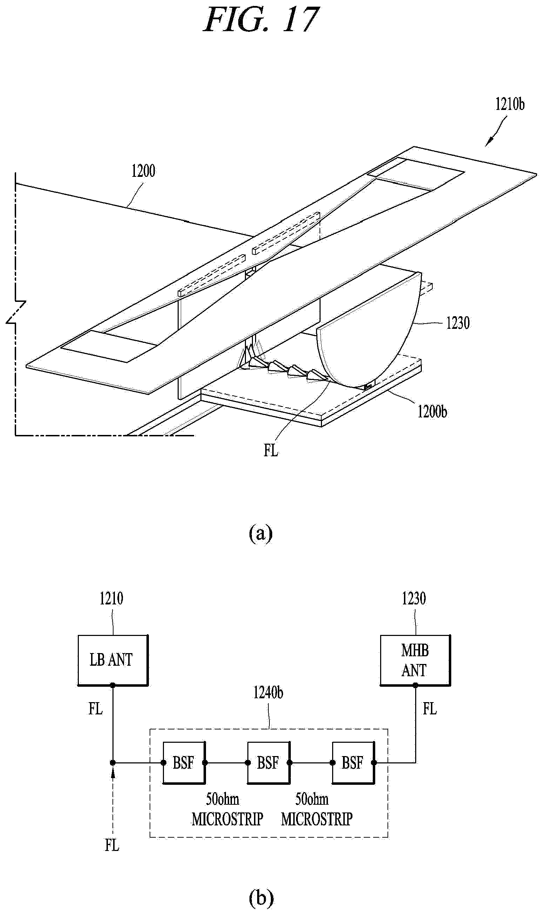

Meanwhile, the slot radiator and the second radiator constituting the radiator module presented herein may be fed by a separate feed structure or a single feed structure. In this regard, FIG. 16 shows a radiator module having a separate feed structure. On the contrary, FIG. 17 shows a radiator module with a single feed structure.

(a) of FIG. 16 shows a structure in which the slot radiator 1210b and the second radiator 1230 are disposed in a separate feed structure, and (b) of FIG. 16 is a block diagram of the separate feed structure in (a) of FIG. 16. (a) of FIG. 17 shows a structure in which the slot radiator 1210 and the second radiator 1230 are disposed in a single feed structure, and (b) of FIG. 17 is a block diagram of the single feed structure in (a) of FIG. 17. In this regard, the slot radiator 1210b is a radiator that operates in the low band (LB), which is the first band. The second radiator 1230 is a radiator that operates in the mid band (MB) and the high band (HB), which are the second band. Accordingly, the slot radiator 1210b operating in the first band may be referred to as a first radiator or an LB antenna. The second radiator 1230 operating in the second band may be referred to as a second radiator or MHB antenna.

Meanwhile, the slot radiator 1210b in (a) of FIG. 16 and (a) of FIG. 17 is not limited to a structure disposed in a front region of the top cover 1320 as shown in FIGS. 11A and 11B. In this regard, the slot radiator in (a) of FIG. 16 and (a) of FIG. 17 may be configured with the slot radiator 1210 disposed in a side region of the top cover 1320 as shown in FIGS. 6A to 7B.

Referring to FIGS. 11B and 16, the slot radiator 1210, 1210b may be connected to the first feed line FL1 of the signal lines, and the second radiator 1230 is connected to the second feed line FL2 of the signal lines. A first signal in the first band transmitted to the first feed line FL1 and a second signal in the second band transmitted to the second feed line FL2 may be separated from each other by a diplexer 1240.

In this regard, the first feed line FL1 may be configured in a feeding structure 1120 of FIG. 11B. Meanwhile, the second feed line FL2 may be configured as the second feed line 1220b of FIG. 11B. The feeding structure 1120 corresponding to the first feed line FL1 and the second feed line 1220b corresponding to the second feed line FL2 may be connected to the diplexer 1240 in (b) of FIG. 16 so as to be separated from each other. Therefore, the first signal in the first band transmitted through the feeding structure 1120 and the second signal in the second band transmitted through the second feed line 1220b may be separated from each other by the diplexer 1240 in (b) of FIG. 16.

Referring to FIGS. 11B and 17, the slot radiator 1210, 1210b and the second radiator 1230 are connected by a signal line provided with a filter part 1240b consisting of one or more filters. The filter part 1240b may be a multi-stage filter consisting of a plurality of filters. The filter part 1240b may be implemented as a band stop filter (BSF), but is not limited thereto. The filter part 1240b may be implemented as at least one of a low pass filter (LPF), a band pass filter (BPF), a high pass filter (HPF), and a band stop filter (BSF).

It may be configured such that the first signal in the first band transmitted through the signal line is transmitted to the slot radiator 1210, 1210b but not transmitted to the second radiator 1230 by the filter part 1240b. Meanwhile, it may be configured such that the second signal in the second band transmitted through the signal line is transmitted to the second radiator 1230 but not transmitted to the slot radiator 1210, 1210b by the filter part. The signal line may be a feed line FL configured to feed the slot radiator 1210, 1210b and the second radiator 1230. The feed line FL is disposed in a single feed line structure rather than the first and second feed lines FL1, FL2 separated from each other as shown in FIG. 16.

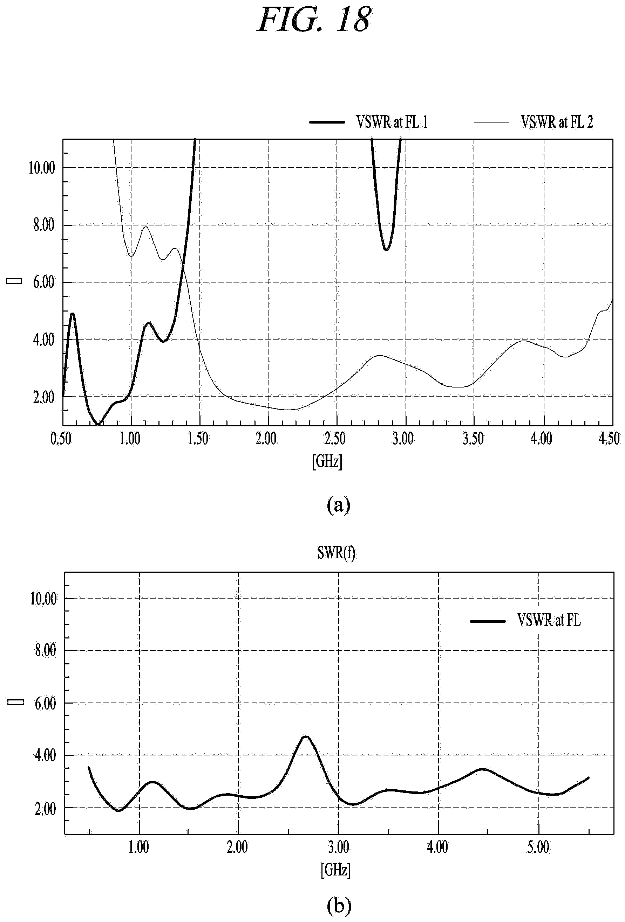

FIG. 18 shows VSWRs of antennas according to the feeding structures of FIGS. 16 and 17. (a) of FIG. 18 shows VSWRs of the slot radiator on a first feed line and the second radiator on a second feed line in a separate feed structure. Referring to FIG. 16 and (a) of FIG. 18, a VSWR on the first feed line FL1 in the separate feed structure corresponds to a VSWR of the slot radiator 1210, 1210b.

In this regard, the slot radiator 1210, 1210b operate as a first radiator (LB antenna) operating in the first band, which is the low band (LB). On the contrary, the second radiator 1230 operates as an MHB antenna operating in the second band corresponding to the mid band (MB) and high band (HB). Isolation between the slot radiator 1210, 1210b and the second radiator 1230 is improved by a mutual separation structure between the slot radiator 1210, 1210b and the second radiator 1230.

(b) of FIG. 18 shows a VSWR of the slot radiator and the second radiator in the feed line having a single feed structure. Referring to FIG. 16 and (b) of FIG. 18, a VSWR on the feed line FL having the single feed structure corresponds to a VSWR of the slot radiator 1210, 1210b and the second radiator 1230.

In this regard, the slot radiator 1210, 1210b operate as a first radiator (LB antenna) operating in the first band, which is the low band (LB). On the contrary, the second radiator 1230 operates as an MHB antenna operating in the second band corresponding to the mid band (MB) and high band (HB). Antenna performance is improved in an entire band through the slot radiator 1210, 1210b and the second radiator 1230 by a coupling structure between the slot radiator 1210, 1210b and the second radiator 1230.

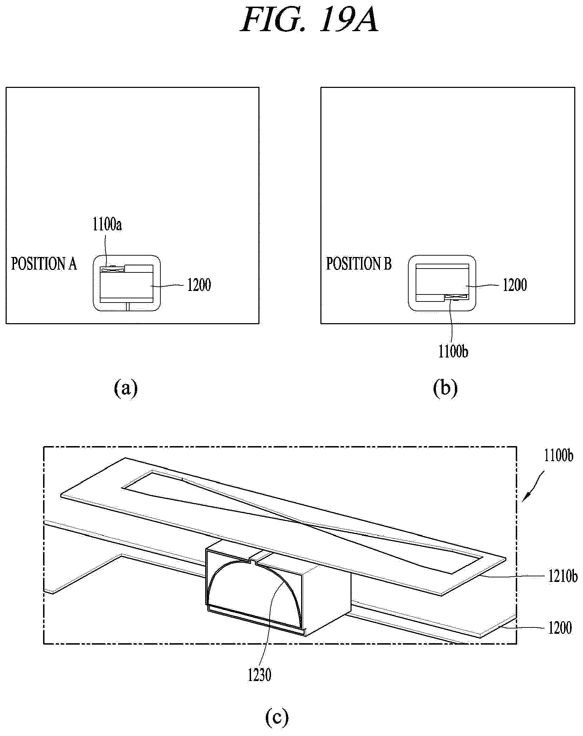

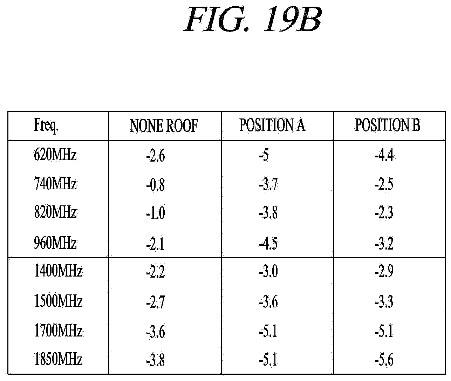

Meanwhile, the radiator module consisting of a plurality of wideband antenna elements presented herein may be disposed at a specific location on the PCB. In this regard, FIG. 19A shows a structure in which radiator modules are disposed at different locations on a PCB. (a) of FIG. 19 shows the radiator module 1100a disposed in a first region on the PCB 1200. Meanwhile, (b) of FIG. 19 shows the radiator module 1100b disposed in a second region on the PCB 1200.

Referring to (a) of FIG 19 and (b) of FIG. 19, it is shown a configuration in which radiator modules 1100a, 1100b are disposed within a roof 2000 of a vehicle. A region of the loop 2000 corresponding to an upper region of the first and second regions where the radiator modules 1100a, 1100b are disposed is formed of a non-metallic material to allow a wireless signal to pass therethrough. (c) of FIG. 19 is an enlarged view of the second region in (b) of FIG. 19 where the radiator module 1100b is disposed.

The first region on the PCB 1200 may be an upper left region on the PCB 1200 corresponding to position A. The second region on the PCB 1200 may be a lower right region on the PCB 1200 corresponding to position B. In this regard, the first radiator module 1100a and the second radiator module 1100b may be disposed in the first and second regions on the PCB 1200, respectively. The first radiator module 1100a and the second radiator module 1100b may be configured to operate simultaneously to perform multi-input multi-output (MIMO).

Meanwhile, FIG. 19B shows a gain characteristic of a radiator module disposed at a specific location as a roof formed of a metal material is disposed in a vehicle. Referring to FIG. 19B, gain characteristics in the LB corresponding to the first band and the MB corresponding to the second band are shown. In this regard, an average gain is shown in a range of about 60 to 90 degrees with respect to a vertical plane of the vehicle. In other words, the average gain is shown in a low elevation angle range of about 0 to 30 degrees with respect to a horizontal place of the vehicle.

Referring to FIGS. 19A and 19B, a slight gain reduction occurs in the first and second bands when a loop made of a metal material is disposed compared to when the loop is not disposed. Meanwhile, in the second band, a change in antenna performance according to a position at which the radiator module is disposed, that is, position A and position B, is not significant. In this regard, an area of a metal region surrounding the first radiator module 1100a disposed at position A is smaller than that of a metal region surrounding the second radiator module 1100b disposed at position B. Accordingly, a gain value of the second radiator module 1100b disposed at position B is predicted to be larger than that of the first radiator module 1100a disposed at position B.

However, in the second band, there is almost no difference between the gain value of the second radiator module 1100b and the gain value of the first radiator module 1100a. Therefore, when both the first radiator module 1100a and the second radiator module 1100b are disposed, there is almost no difference in antenna performance between them. Accordingly, a second signal in the second band may be configured to be radiated through the first radiator module 1100a, the second radiator module 1100b, or both.

On the contrary, in the first band, which is the low band (LB), a gain value of the second radiator module 1100b is larger than that of the first radiator module 1100a. Therefore, when both the first radiator module 1100a and the second radiator module 1100b are disposed, it may be advantageous in terms of antenna performance to radiate a wireless signal through the second radiator module 1100b. Accordingly, the first signal in the first band may be configured to be radiated through the second radiator module 1100b.

In the above, an antenna module having a wideband antenna element according to this specification has been described. It will be clearly understood by those skilled in the art that various changes and modifications to the aforementioned embodiments related to the antenna module are made without departing from the idea and scope of the present disclosure. Therefore, it should be understood that such various changes and modifications to the implementations fall within the scope of the appended claims.

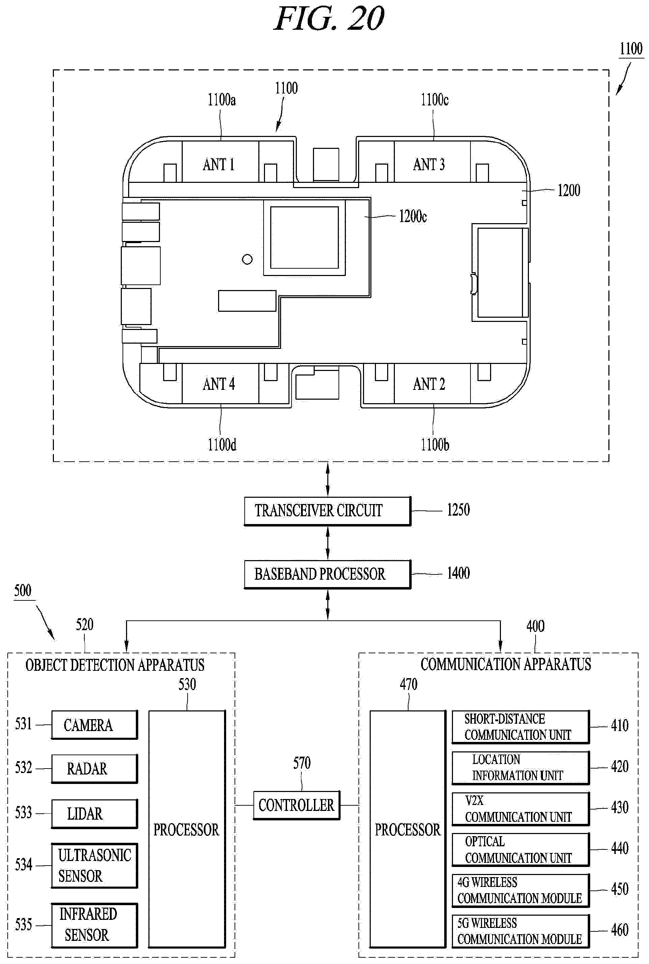

Meanwhile, FIG. 20 shows a configuration diagram of an antenna system according to an embodiment and a vehicle on which the antenna system is mounted. FIG. 20 shows a configuration diagram of a vehicle in which an antenna module corresponding to an antenna system is disposed inside a vehicle roof to perform communication with nearby electronic devices, vehicles, and infrastructures.

Referring to FIG. 20, the wideband antenna module 1000 may be mounted on the vehicle. The antenna module 1000 may perform short-range communication, wireless communication, V2X communication, and the like by itself or through the communication apparatus 400. To this end, the baseband processor 1400 may perform control such that a signal is received from or transmitted to the adjacent vehicle, the RSU, and the base station through the antenna module 1000.

Alternatively, the baseband processor 1400 may perform control such that a signal is received from or transmitted to the adjacent vehicle, the RSU, the adjacent object, and the base station through the communication apparatus 400. Here, the information related to adjacent objects may be acquired through the object detecting apparatus such as the camera 531, the radar 532, the lidar 533, and the sensors 534 and 535 of the vehicle 300. Alternatively, the baseband processor 1400 may control the communication device 400 and the antenna module 1000 such that a signal is received from or transmitted to the adjacent vehicle, the RSU, the adjacent object, and the base station.

Meanwhile, referring to FIGS. 1A to 20, the vehicle 500 having the antenna module 1000 may include the plurality of antennas 1100, the transceiver circuit 1250, and the baseband processor 1400. The vehicle 500 may further include the object detecting apparatus 520. The vehicle 500 may further include the communication apparatus 400. Here, the communication apparatus 400 may be configured to perform wireless communication through the antenna unit.

Referring to FIGS. 1A to 20, the vehicle 500 may be provided with the antenna module 1000. The antenna module 1000 may be disposed below a roof of the vehicle, and configured to communicate with at least one of an adjacent vehicle, a road side unit (RSU), and a base station through a processor. The antenna module 1000 may perform a telematics operation through wireless communication in the vehicle, and thus may also be referred to as a telematics module. In this regard, the antenna PCB 1200 in the antenna module 1000 may be coupled to a telematics module 1200c that performs a telematics function. In this regard, the antenna PCB 1200 and the telematics module 1200c may be coupled to interface with each other on the same plane.

Referring to 1A to 20, the vehicle 500 provided with the antenna module 1000 according to another aspect of this specification will be described. The vehicle 500 includes the antenna module 1000 disposed below the roof of the vehicle. The vehicle 500 may further include the processor 1400 disposed inside or outside the antenna module 1000 and configured to communicate with at least one of an adjacent vehicle, a road side unit (RSU), and a base station.

The antenna module 1000 may include a PCB 1200, a bottom cover 1310, a top cover 1320, a slot radiator 1210, 1210b, and a feeding structure 1220. A transmission line may be disposed on the PCB 1200, and the transmission line may be a CPW transmission line. The bottom cover 1310 may be configured such that the PC 1200 is disposed therein to be attached to a vehicle. The top cover 1320 may be fastened to the bottom cover 1310 to accommodate the PCB 1200 therein, and have a metal plate 1321, 1322 disposed in a partial region made of a dielectric.

The slot radiator 1210, 1210b may be configured to radiate a wireless signal through the slot region SR disposed on the metal plate 1321, 1322 and a partial region of the top cover 1320. The feeding structure 1220 is configured to transmit a wireless signal of the transmission line disposed on the PCB 1200 to the slot radiator 1210, 1210b so as to radiate the wireless signal through the slot radiator 1210, 1210b. The slot radiator 1210, 1210b may be disposed to have a first length in a first axis direction with respect to the center point of the slot region SR, and may be configured to gradually increase in width in a second axis direction with respect to the center point.

The transmission line on the PCB 1200 or the auxiliary PCB 1200b may be configured as a CPW transmission line having ground patterns disposed on both sides of the signal line. The metal plate 1321 may be disposed in a side region of the top cover 1320. The metal plate 1321 may be connected to or coupled to be spaced apart from the feeding structure 1220 connected in perpendicular to the signal line of the CPW transmission line.

The feeding structure 1220 may include a first connection portion 1221 and a second connection portion 1222. The first connection portion 1221 may be connected in perpendicular to the signal line of the CPW transmission line, and may extend in a height direction of the PCB 1200 to a point higher than the center point of the slot region SR so that the wireless signal is coupled to the slot region SR. The second connection portion 1222 may be configured to be spaced apart from the metal plate 1321 by a predetermined distance at a point higher than the center point.

The antenna module 1000 may further include an auxiliary PCB 1200b disposed perpendicular to the PCB 1200. The metal plate 1322 may be disposed in a front region of the top cover 1320, and a CPW transmission line having ground patterns disposed on both sides of the signal line may be disposed on the auxiliary PCB 1200b. The metal plate 1322 may be connected to or coupled to be spaced apart from the feeding structure 1220 connected in perpendicular to the signal line of the CPW transmission line.

The feeding structure 1220 may include a first connection portion 1221 and a second connection portion 1222. The first connection portion 1221 may be connected in perpendicular to the signal line of the CPW transmission line of the PCB 1200, and may extend in a height direction of the auxiliary PCB 1200b to a point higher than the center point of the slot region so that the wireless signal is coupled to the slot region SR. The second connection portion 1222 may be configured to be spaced apart from the metal plate 1322 by a predetermined distance at a point higher than the center point of the slot region.

The antenna module 1000 may further include a second radiator 1230 connected to the signal line of the transmission line on the auxiliary PCB 1200b and disposed perpendicular to the metal plate 1321, 1322. The slot radiator 1210, 1210b may operate in a first band, and the second radiator 1230 may operate in a second band higher than the first band. The antenna module 1000 may include a plurality of antennas consisting of the slot radiator 1210, 1210b and a second radiator 1230. The plurality of antennas may include a first antenna (ANT1) 1100a and a second antenna (ANT2) 1100b. The plurality of antennas may include a third antenna (ANT3) 1100c and a fourth antenna (ANT4) 1100d.

The processor 1400 may control to perform multi-input multi-output (MIMO) in the first band through the first antenna (ANT1) 1100a and the second antenna (ANT2, 1100b). The processor 1400 may control a signal to be transmitted and received in the first band only through the first antenna (ANT1) 1100a. The processor 1400 may control to perform multi-input multi-output (MIMO) in a second band higher than the first band through the first antenna (ANT1) 1100a and the second antenna (ANT2) 1100b. In this regard, an area of a metal region surrounding a second region where the second antenna (ANT2) 1100b is disposed may be configured to be larger than that of a first region where the first antenna (ANT1) 1100a is disposed.

The transceiver circuit 1250 may be operably coupled to each radiator module 1100. The processor 1400 may be operably coupled to the transceiver circuit 1250. The processor 1400 may be a baseband processor corresponding to a modem, but is not limited thereto and may be any processor that controls the transceiver circuit 1250. The processor 1400 of the vehicle may be implemented as a network access device (NAD).

The transceiver circuit 1250 may be operably coupled to the MIMO antennas ANT1 to ANT4. The transceiver circuit 1250 may include a front end module (FEM) such as a power amplifier or a receiving amplifier. As another example, the front end module (FEM) may be disposed between the transceiver circuit 1250 and the antenna, separately from the transceiver circuit 1250. The transceiver circuit 1250 may control the amplitude and/or phase of signals transmitted to the MIMO antennas ANT1 to ANT4 or control only some antenna modules to operate by adjusting the gain or input or output power of the power amplifier or the receiving amplifier.

The processor 1400 may be operably coupled to the transceiver circuit 1250 and may be configured to control the transceiver circuit 1250. The processor 1400 may control the transceiver circuit 1250 to control the amplitude and/or phase of the signals transmitted to the MIMO antennas ANT1 to ANT4 or to operate only some antenna modules. The processor 1400 may perform communication with at least one of the adjacent vehicle, the road side unit (RSU), and the base station through the transceiver circuit 1250.

In a case where there is a need to simultaneously receive information from various entities such as the adjacent vehicle, the RSU, and the base station for autonomous driving, etc., information may be received and transmitted through MIMO. Therefore, the vehicle may receive different information from various entities at the same time to improve its communication capacity. Therefore, the communication capacity of the vehicle can be improved through the MIMO without increasing a bandwidth.

Alternatively, the vehicle may simultaneously receive the same information from various entities, so as to improve reliability of surrounding information and decrease latency. Accordingly, Ultra Reliable Low Latency Communication (URLLC) can be performed in the vehicle and the vehicle can operate as a URLLC UE. To this end, a base station that performs scheduling may preferentially allocate a time slot for the vehicle operating as the URLLC UE. For this purpose, some of specific time-frequency resources already allocated to other UEs may be punctured.

As described above, the plurality of antennas ANT1 to ANT4 within the antenna module 1000 may operate in the full band including the low band (LB), the mid band (MB), and the high band (HB). Here, the low band (LB) may be referred to as the first (frequency) band and the mid band (MB) and the high band (HB) may be referred to as the second (frequency) band. As another example, when the antenna system 1000 operates in the mid band (MB) and the high band (HB), the mid band (MB) is referred to as a first (frequency) band and the high band (HB) is referred to as a second (frequency) band. The 5G sub-6 band may be the same band as the LTE band in case of LTE re-farming. When 5G NR operates in a band separate from LTE, it may operate in the high band (HB) or a higher band. The 5G sub-6 band operating in the high band (HB) or higher band may also be referred to as a second (frequency) band.

The baseband processor 1400 can perform MIMO through some of the plurality of antenna elements ANT1 to ANT4 in the first frequency band. Also, the baseband processor 1400 can perform MIMO through some of the plurality of antenna elements ANT1 to ANT4 in the second frequency band. In this regard, the baseband processor 1400 can perform MIMO by using antenna elements that are sufficiently spaced apart from each other and disposed by being rotated at a predetermined angle. This can improve isolation between the first and second signals within the same band.

The baseband processor 1400 may control the transceiver circuit 1250 to receive the second signal in the second band while receiving the first signal in the first band through one of the first to fourth antennas ANT1 to ANT4. In this case, there is an advantage capable of performing carrier aggregation (CA) through one antenna.

Alternatively, the baseband processor 1400 may control the transceiver circuit 1250 to receive the second signal in the second band through one of the third antenna ANT3 and the fourth antenna ANT4 while receiving the first signal in the first band through one of the first antenna ANT1 and the second antenna ANT2. In this case, there may be provided an advantage that each antenna can be designed to optimally operate in a corresponding band.

Therefore, the baseband processor 1400 may perform carrier aggregation (CA) through a band in which the first frequency band and the second frequency band are combined. When it is necessary to receive a large amount of data for autonomous driving or the like, reception in a broad band may be allowed through the CA.

Accordingly, eMBB (Enhanced Mobile Broad Band) communication can be performed in the vehicle and the vehicle can operate as an eMBB UE. To this end, the base station that performs scheduling may allocate a wideband frequency resource to the vehicle that operates as the eMBB UE. For this purpose, carrier aggregation (CA) may be performed on spare frequency bands except for frequency resources already allocated to other UEs.

Regarding the frequency band, the low band (LB), the mid band (MB), and the high band (HB) may be referred to as the first band, the second band, and the third band, respectively. The antenna system 1000 may operate as a single antenna in the first band, the second band, and the third band corresponding to the low band (LB), the middle band (MB), and the high band (HB). In this regard, the processor 1400 may determine a resource region allocated through a physical downlink control channel (PDCCH). The processor 1400 may control the transceiver circuit 1250 to perform carrier aggregation in two or more of the first to third bands based on the allocated resource region.

The processor 1400 may perform MIMO in an EN-DC state through the first to fourth antennas ANT1 to ANT4. For example, the processor 1400 may perform an EN-DC operation through the first antenna ANT1 and the second antenna ANT2, and MIMO through the third antenna ANT3 and the fourth antenna ANT4.

In this regard, when the EN-DC operation is performed between 4G and 5G communication systems using different bands, the processor 1400 may perform the EN-DC operation through a plurality of antennas in one antenna system. Accordingly, an interference level between MIMO streams using the same band can be reduced. On the other hand, when the EN-DC operation is performed between the 4G and 5G communication systems using the same band, the processor 1400 may perform the EN-DC operation through a plurality of antennas in different antenna systems. In this case, in order to reduce the interference level in the low band (LB), the MIMO operation through the plurality of antennas in the same antenna system may be performed in the mid band (MB) or higher.

It will be clearly understood by those skilled in the art that various modifications and alternations for the aforementioned implementations related to the antenna system having the plurality of antennas, the vehicle having the antenna system, and the control operations thereof are made without departing from the idea and scope of the present disclosure. Therefore, it should be understood that such various modifications and alternations for the implementations fall within the scope of the appended claims.

In the above, an antenna module having a wideband antenna element disposed in a vehicle and a vehicle equipped with the antenna module have been described. The technical effects of such an antenna module having a wideband antenna element in a vehicle and a vehicle equipped with the antenna module will be described as follows.

According to this specification, it aims to provide a bow-tie type wideband antenna element capable of operating in a low band (LB) of the 4G/5G band while being disposed in a vehicle.

According to this specification, a high-efficiency wideband antenna element having a high antenna gain while operating in a wideband may be implemented through a structure in which a bow-tie type antenna element is connected to a feed line on a PCB.

According to this specification, a wideband antenna element may be disposed on a surface of a non-metallic antenna module, thereby maintaining antenna performance at a predetermined level even when the exterior of a vehicle body or roof is formed of a metal material.

According to this specification, a wideband antenna element may be disposed on a surface of a non-metallic antenna module, thereby improving antenna performance while maintaining a height of an entire antenna system below a predetermined level.

According to this specification, a structure for mounting an antenna system capable of operating in a wideband on a vehicle to support various communication systems may be presented.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

In relation to the foregoing description, the antenna system mounted in the vehicle and the operation of controlling the same may be implemented by software, firmware, or a combination thereof. Meanwhile, the design of the antenna system mounted in the vehicle and the configuration of controlling the antenna system may be implemented as computer-readable codes in a program-recorded medium. The computer-readable medium may include all types of recording devices each storing data readable by a computer system. Examples of such computer-readable media may include hard disk drive (HDD), solid state disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the invention should be determined by reasonable interpretation of the appended claims and all changes that come within the equivalent scope of the invention are included in the scope of the disclosure.

## Claims

1. An antenna module mounted on a vehicle, the antenna module comprising:
a PCB having a transmission line disposed thereon; a bottom cover in which the PCB is disposed;
a top cover fastened to the bottom cover to accommodate the PCB therein, the top cover having a metal plate disposed in a partial region made of a dielectric;
a slot radiator configured to radiate a wireless signal through a slot region disposed on the metal plate and a partial region of the top cover; and
a feeding structure configured to transmit a wireless signal of the transmission line disposed on the PCB to the slot radiator so as to radiate the wireless signal through the slot radiator,
wherein the slot radiator is disposed to have a first length in a first axis direction with respect to a center point of the slot region, and configured to gradually increase in width in a second axis direction with respect to the center point.

2. The antenna module of claim 1, wherein the metal plate is disposed in a side region of the top cover, and
wherein the slot radiator is configured to surround the slot region at a first frequency in an operating band of the slot radiator, and operates in a slot mode by a current distribution formed in different directions in upper and lower regions of the slot region, and operates in a patch mode by a current distribution formed in the same direction on the metal plate at a second frequency higher than the first frequency.

3. The antenna module of claim 1, wherein the metal plate is disposed in an inner region of the top cover and disposed above the PCB in parallel to the PCB, and
wherein the slot radiator operates in a first synthesis mode in which a slot mode and a patch mode are synthesized at a first frequency in an operating band of the slot radiator, and operates in the slot mode at a second frequency higher than the first frequency.

4. The antenna module of claim 3, wherein the slot mode is configured such that a current distribution is formed in different directions in upper and lower regions of the slot region, and
wherein the patch mode is configured such that a current distribution is formed in the same direction on the metal plate.

5. The antenna module of claim 4, wherein the slot radiator operates in a second synthesis mode in which the slot mode and the patch mode are synthesized at a third frequency between the first frequency and the second frequency, and operates in the first synthesis mode at a fourth frequency between the third frequency and the second frequency, and
wherein a direction of a current distribution formed in the slot region in the second synthesis mode is formed in a direction opposite to that of a current distribution formed in the slot region in the first synthesis mode.

6. The antenna module of claim 1, wherein the metal plate is formed using an injection method to be attached to a partial region of the top cover.

7. The antenna module of claim 1, wherein the transmission line is a CPW transmission line having ground patterns disposed on both sides of a signal line, and
wherein the metal plate is disposed on a side region of the top cover, and the metal plate is connected to the feeding structure connected in perpendicular to the signal line of the CPW transmission line.

8. The antenna module of claim 7, wherein the feeding structure comprises:
a first connection portion connected in perpendicular to the signal line of the CPW transmission line and extending to a point higher than the center point of the slot region in a height direction of the PCB so that a wireless signal is coupled to the slot region; and
a second connection portion configured to be spaced apart from the metal plate by a predetermined distance at a point higher than the center point.

9. The antenna module of claim 1, further comprising:
an auxiliary PCB disposed perpendicular to the PCB,
wherein the metal plate is disposed on the top cover, and a CPW transmission line is disposed on the auxiliary PCB having ground patterns disposed on both sides of a signal line, and
wherein the metal plate is coupled to the feeding structure connected in perpendicular to the signal line of the CPW transmission line to be spaced apart therefrom by a predetermined distance or connected thereto.

10. The antenna module of claim 9, wherein the feeding structure comprises:
a first connection portion connected in perpendicular to the signal line of the CPW transmission line and extending to a point higher than the center point of the slot region in a height direction of the auxiliary PCB so that a wireless signal is coupled to the slot region; and
a second connection portion configured to be spaced apart from the metal plate by a predetermined distance at a point higher than the center point.

11. The antenna module of claim 8 or 10, wherein the second connection portion is disposed more adjacent to the metal plate than the first connection portion such that a second distance at which the second connection portion is spaced apart from the metal plate is smaller than a first distance at which the first connection portion is spaced apart from the metal plate.

12. The antenna module of claim 8 or 10, wherein the first connection portion is configured with a first width and a first length to ensure impedance matching between the transmission line and the slot radiator when a wireless signal is applied to the slot region, and
wherein the second connection portion is configured with a second width wider than the first width and a second length shorter than the first length.

13. The antenna module of claim 7 or 9, further comprising:
a second radiator connected to the signal line of the CPW transmission line and disposed perpendicular to the metal plate,
wherein the slot radiator operates in a first band, and the second radiator operates in a second band higher than the first band.

14. The antenna module of claim 13, wherein the slot radiator is connected to a first feed line of the signal line, and the second radiator is connected to a second feed line of the signal line, and
wherein a first signal in the first band transmitted to the first feed line and a second signal in the second band transmitted to the second feed line are separated from each other by a diplexer.

15. The antenna module of claim 13, wherein the slot radiator and the second radiator are connected by the signal line provided with a filter part consisting of one or more filters, and
wherein the first signal in the first band transmitted through the signal line is transmitted to the slot radiator but not transmitted to the second radiator by the filter part, and the second signal in the second band transmitted through the signal line is transmitted to the second radiator but not transmitted to the first radiator by the filter part.

16. The antenna module of claim 1, wherein the slot region comprises:
a first region disposed in a tapering structure to gradually increase in width in the second axis direction with respect to the center point that is coupling-fed by the feeding structure; and
a second region disposed to have a constant width in the second axis direction, and
wherein the first region of the slot region is disposed in a first side region of the top cover, and at least part of the second region is disposed in a second side region adjacent to the first side region.

17. A vehicle having antenna modules, the vehicle comprising:
an antenna module disposed below a roof of the vehicle; and
a processor disposed inside or outside the antenna module, and configured to communicate with at least one of an adjacent vehicle, a road side unit (RSU), and a base station,
wherein the antenna module further comprises:
a PCB having a transmission line disposed thereon;
a bottom cover having the PCB disposed therein, the bottom cover configured to be attached to the vehicle;
a top cover fastened to the bottom cover to accommodate the PCB therein, the top cover having a metal plate disposed in a partial region made of a dielectric;
a slot radiator configured to radiate a wireless signal through a slot region disposed on the metal plate and a partial region of the top cover; and
a feeding structure configured to transmit a wireless signal of the transmission line disposed on the PCB to the slot radiator so as to radiate the wireless signal through the slot radiator, and
wherein the slot radiator is disposed to have a first length in a first axis direction with respect to a center point of the slot region, and configured to gradually increase in width in a second axis direction with respect to the center point.

18. The vehicle of claim 17, wherein the transmission line is a CPW transmission line having ground patterns disposed on both sides of a signal line,
wherein the metal plate is disposed on a side region of the top cover, and the metal plate is connected to or coupled to the feeding structure connected in perpendicular to the signal line of the CPW transmission line to be spaced apart therefrom, and
wherein the feeding structure comprises:
a first connection portion connected in perpendicular to the signal line of the CPW transmission line and extending to a point higher than the center point of the slot region in a height direction of the PCB so that a wireless signal is coupled to the slot region; and
a second connection portion configured to be spaced apart from the metal plate by a predetermined distance at a point higher than the center point.

19. The vehicle of claim 18, wherein the antenna module further comprises an auxiliary PCB disposed perpendicular to the PCB,
wherein the metal plate is disposed on the top cover, and a CPW transmission line is disposed on the auxiliary PCB having ground patterns disposed on both sides of a signal line,
wherein the metal plate is connected to or coupled to the feeding structure connected in perpendicular to the signal line of the CPW transmission line to be spaced apart therefrom, and
wherein the feeding structure comprises:
a first connection portion connected in perpendicular to the signal line of the CPW transmission line and extending to a point higher than the center point of the slot region in a height direction of the auxiliary PCB so that a wireless signal is coupled to the slot region; and
a second connection portion configured to be spaced apart from the metal plate by a predetermined distance at a point higher than the center point.

20. The vehicle of claim 17, wherein the antenna module further comprises a second radiator connected to a signal line of the transmission line and disposed perpendicular to the metal plate, the slot radiator operates in a first band, and the second radiator operates in a second band higher than the first band,
wherein the antenna module comprises a first antenna and a second antenna consisting of the slot radiator and the second radiator,
wherein the processor controls to transmit and receive a signal in a first band through the first antenna, and controls to perform multi-input multi-output (MIMO) in a second band higher than the first band through the first antenna and the second antenna, and
wherein an area of a metal region surrounding a second region where the second antenna is disposed is larger than that of a first region where the first antenna is disposed.
